(19) 

Europäisches
Patentamt
European
Patent Office
Office européen
des brevets

(11)     EP 3 863 040 A1

(12)                    EUROPEAN PATENT APPLICATION

(43) Date of publication:
     11.08.2021  Bulletin 2021/32

(51) Int Cl.:
     $H01J 37/153$ $^{(2006.01)}$

(21) Application number: 20156253.5

(22) Date of filing: 07.02.2020

(84) Designated Contracting States:
     AL AT BE BG CH CY CZ DE DK EE ES FI FR GB
     GR HR HU IE IS IT LI LT LU LV MC MK MT NL NO
     PL PT RO RS SE SI SK SM TR
     Designated Extension States:
     BA ME
     Designated Validation States:
     KH MA MD TN

(71) Applicant: ASML Netherlands B.V.
     5500 AH Veldhoven (NL)

(72) Inventors:
     • BRANDT, Pieter, Lucas
       5500 AH Veldhoven (NL)
     • WIELAND, Marco, Jan-Jaco
       5500 AH Veldhoven (NL)

(74) Representative: ASML Netherlands B.V.
     Corporate Intellectual Property
     P.O. Box 324
     5500 AH Veldhoven (NL)

(54)     CHARGED PARTICLE MANIPULATOR DEVICE

(57)     A multi-beam manipulator device operates on sub-beams of a multi-beam to deflect the sub-beam paths. The device comprises: an electrode as pairs of parallel surfaces. Each pair of parallel surfaces comprises a first surface that is arranged along a side of a corresponding line of sub-beams and a second surface that is arranged parallel to the first surface and along an opposite side of the corresponding line of sub-beam paths. A first pair of parallel surfaces is configured to electro-statically interact with an entire line of sub-beams in the multi-beam so that it is capable of applying a deflection amount to the paths of sub-beams in a first direction. A second pair of parallel surfaces is configured to electro-statically interact with an entire line of sub-beams in the multi-beam so that it is capable of applying another deflection amount to the paths of sub-beams in a second direction.

## Fig. 5

EP 3 863 040 A1

## Description

FIELD

The embodiments provided herein generally relate to the manipulation of charged particles in a multi-beam charged particle apparatus. Embodiments provide a plurality of pairs of electrodes with each pair of electrodes being arranged to simultaneously manipulate a plurality of sub-beams of charged particles.

BACKGROUND

When manufacturing semiconductor integrated circuit (IC) chips, undesired pattern defects, as a consequence of, for example, optical effects and incidental particles, inevitably occur on a substrate (i.e. wafer) or a mask during the fabrication processes, thereby reducing the yield. Monitoring the extent of the undesired pattern defects is therefore an important process in the manufacture of IC chips. More generally, the inspection and/or measurement of a surface of a substrate, or other object/material, is an import process during and/or after its manufacture.

Pattern inspection tools with a charged particle beam have been used to inspect objects, for example to detect pattern defects. These tools typically use electron microscopy techniques, such as a scanning electron microscope (SEM). In a SEM, a primary electron beam of electrons at a relatively high energy is targeted with a final deceleration step in order to land on a sample at a relatively low landing energy. The beam of electrons is focused as a probing spot on the sample. The interactions between the material structure at the probing spot and the landing electrons from the beam of electrons cause electrons to be emitted from the surface, such as secondary electrons, backscattered electrons or Auger electrons. The generated secondary electrons may be emitted from the material structure of the sample. By scanning the primary electron beam as the probing spot over the sample surface, secondary electrons can be emitted across the surface of the sample. By collecting these emitted secondary electrons from the sample surface, a pattern inspection tool may obtain an image representing characteristics of the material structure of the surface of the sample.

Another application for a charged particle beam is lithography. The charged particle beam reacts with a resist layer on the surface of a substrate. A desired pattern in the resist can be created by controlling the locations on the resist layer that the charged particle beam is directed towards.

A charged particle apparatus may be an apparatus for generating, illuminating, projecting and/or detecting one or more beams of charged particles. Within a charged particle apparatus, there is a general need to improve on known techniques for manipulating one or more beams of charged particles.

SUMMARY

The embodiments provided herein disclose a manipulator device for manipulating one or more beams of charged particles. The manipulator device may be a deflector for simultaneously deflecting a plurality of sub-beams in a multi-beam. The manipulator device may be comprised by a charged particle apparatus. The charged particle apparatus may be an apparatus for generating, illuminating, projecting and/or detecting one or more beams of charged particles.

According to a first aspect of the invention, there is provided a multi-beam manipulator device configured to operate on the paths of a plurality of sub-beams in a multi-beam of charged particles to thereby deflect the plurality of sub-beam paths, wherein the sub-beams arranged in an array in which the sub-beams are arranged in a plurality of lines, the multi-beam manipulator device comprising: a set of electrodes comprising a plurality of pairs of parallel planar electrode surfaces; wherein: a first pair of parallel planar electrode surfaces in the set comprises a first planar electrode surface that is arranged along a side of one of the lines of sub-beams and a second planar electrode surface that is arranged parallel to the first planar electrode surface and along an opposite side of said one of the lines of sub-beam paths; a second pair of parallel planar electrode surfaces in the set comprises a first planar electrode surface that is arranged along a side of a different one of the lines of sub-beam paths and a second planar electrode surface that is arranged parallel to the first planar electrode surface and along an opposite side of said different one of the lines of sub-beam paths; the first pair of parallel planar electrode surfaces is configured to electro-statically interact with an entire line of sub-beams in the multi-beam so that it is capable of applying a first deflection amount to the paths of sub-beams in a first direction; the second pair of parallel planar electrode surfaces is configured to electro-statically interact with an entire line of sub-beams in the multi-beam so that it is capable of applying a second deflection amount to the paths of sub-beams in a second direction; and the first direction is opposite to the second direction.

According to a second aspect of the invention, there is provided a multi-beam manipulator arrangement comprising: a first multi-beam manipulator device according to the first aspect; and one or more further multi-beam manipulator devices, wherein each of the one or more further multi-beam manipulator devices is a multi-beam manipulator device according to the first aspect; wherein, each multi-beam manipulator device is arranged at a different position along the charged particle optical axis of the multi-beam manipulator arrangement.

According to a third aspect of the invention, there is provided a charged particle system comprising: a source of charged particles arranged to emit a beam; a multi-beam generator arranged to generate a multi-beam in dependence on the beam, wherein the multi-beam comprises a plurality of sub-beams; and either a multi-beam manipulator device according to the first aspect, or a multi-beam manipulator arrangement according to the second aspect, configured to manipulate the paths of sub-beams in the multi-beam generated by the multi-beam generator.

According to a fourth aspect of the invention, there is provided an e-beam inspection tool comprising a charged particle system according to the third aspect.

According to a fifth aspect of the invention, there is provided an e-beam lithography tool comprising a charged particle system according to the third aspect.

According to a sixth aspect of the invention, there is provided a multi-beam manipulator device configured to operate on a plurality of sub-beam paths in a multi-beam of charged particles so as to deflect the plurality of sub-beam paths, wherein the sub-beams arranged in an array in which the sub-beams are arranged in a series of lines, the multi-beam manipulator device comprising: a plurality of pairs of parallel planar electrode surfaces; wherein: a first pair of parallel planar electrode surfaces comprises two opposing planar, parallel electrode surfaces that are arranged either side along at least one of the lines of sub-beams; a second pair of parallel planar electrode surfaces comprises two opposing planar, parallel electrode surfaces that are arranged either side along at least another of the lines of sub-beams; the first pair and second pair of parallel planar electrode surfaces extend across the multi-beam to cross the array and are configured, in operation, to interact electrostatically with the respective sub-beam paths in the lines between the pairs of surfaces.

According to a seventh aspect of the invention, there is provided a multi-beam manipulator configured to manipulate an array of sub-beam paths of a multi-beam of charged particles, the sub-beams arranged in lines in the array, the lines being in at least two different line directions, the multi-beam manipulator device comprising: a number of deflector devices corresponding to the number of line directions in the array and arranged at different positions on the path of the multi-beam, wherein, each deflector device comprises a plurality of pairs of parallel planar electrode surfaces, the parallel planar electrode surfaces of each deflector device aligned with a different line direction, the plurality of pairs of parallel planar electrode surfaces comprising: a first pair of parallel planar electrode surfaces comprising two opposing planar, parallel electrode surfaces that are arranged either side along at least one of the lines of sub-beams; a second pair of parallel planar electrode surfaces comprising two opposing planar, parallel electrode surfaces that are arranged either side along at least another of the lines of sub-beams, the at least another of the lines of sub-beams being parallel with the at least one of the lines of sub-beams; and the first pair and second pair of parallel planar electrode surfaces extending across the multi-beam to cross the array and configured, in operation, to interact electrostatically with the respective sub-beam paths in the lines between the pairs of surfaces.

According to an eighth aspect of the invention, there is provided a multi-beam manipulator configured to manipulate an array of sub-beam paths of a multi-beam of charged particles, the sub-beams arranged in lines in the array, the lines being in at least two different line directions, the multi-beam manipulator device comprising: a number of deflector devices corresponding to the number of line directions in the array and positioned along the multi-beam path, wherein each deflector device comprises a plurality planar, parallel opposing electrode surfaces, the planar, parallel electrode surfaces of each deflector device aligned with a different line direction, the plurality of pairs of parallel planar electrode surfaces comprising: at least two pairs of opposing parallel planar electrode surfaces in which each pair of opposing planar, parallel surfaces are configured to cross across the multi-beam array either side of different at least one line of sub-beam paths, so that in operation each pair of opposing parallel planar electrode surfaces interact electrostatically with all of the sub-beam paths in the respective at least one line between said surfaces.

According to a ninth aspect of the invention, there is provided a method of deflecting the paths of a plurality of sub-beams in a multi-beam of charged particles, wherein the sub-beams arranged in an array in which the sub-beams are arranged in a plurality of lines, the method comprising: electro-statically interacting with a first entire line of sub-beams in the multi-beam so that a first deflection amount is applied to the paths of the sub-beams in a first direction; and electro-statically interacting with a second entire line of sub-beams in the multi-beam so that a second deflection amount is applied to the paths of sub-beams in a second direction, wherein the first direction is opposite to the second direction.

Other advantages of the present invention will become apparent from the following description taken in conjunction with the accompanying drawings wherein are set forth, by way of illustration and example, certain embodiments of the present invention.

BRIEF DESCRIPTION OF FIGURES

The above and other aspects of the present disclosure will become more apparent from the description of exemplary embodiments, taken in conjunction with the accompanying drawings.

FIG. 1 is a schematic diagram illustrating an exemplary charged particle beam inspection apparatus.
FIG. 2 is a schematic diagram illustrating an exemplary multi-beam apparatus that is part of the exemplary charged particle beam inspection apparatus of FIG. 1.
FIG. 3 is a schematic diagram of exemplary multi-beam apparatus illustrating an exemplary configuration of source conversion unit of the exemplary charged particle beam inspection apparatus of FIG.

**1.**

**FIG. 4** is a schematic diagram of a manipulator device according to an embodiment.

**FIG. 5** is a schematic diagram of a manipulator device according to an embodiment.

**FIG. 6** shows an arrangement of two manipulator devices according to an embodiment.

**FIG. 7A** is a schematic view of sub-beams in an arrangement of lines of sub-beams.

**FIG. 7B** shows how a plurality of manipulator devices may be aligned according to an embodiment.

**FIG. 8** shows a manipulator array that comprises a plurality of manipulators for manipulating sub-beams.

**FIG. 9** is a schematic diagram showing a cross-section through part of a charged particle apparatus.

DESCRIPTION OF EMBODIMENTS

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

The enhanced computing power of electronic devices, which reduces the physical size of the devices, can be accomplished by significantly increasing the packing density of circuit components such as transistors, capacitors, diodes, etc. on an IC chip. This has been enabled by increased resolution enabling yet smaller structures to be made. For example, an IC chip of a smart phone, which is the size of a thumbnail and available in, or earlier than, 2019, may include over 2 billion transistors, the size of each transistor being less than 1/1000th of a human hair. Thus, it is not surprising that semiconductor IC manufacturing is a complex and time-consuming process, with hundreds of individual steps. Errors in even one step have the potential to dramatically affect the functioning of the final product. Just one "killer defect" can cause device failure. The goal of the manufacturing process is to improve the overall yield of the process. For example, to obtain a 75% yield for a 50-step process (where a step can indicate the number of layers formed on a wafer), each individual step must have a yield greater than 99.4%,. If an individual step has a yield of 95%, the overall process yield would be as low as 7%.

While high process yield is desirable in an IC chip manufacturing facility, maintaining a high substrate (i.e. wafer) throughput, defined as the number of substrates processed per hour, is also essential. High process yield and high substrate throughput can be impacted by the presence of a defect. This is especially if operator intervention is required for reviewing the defects. Thus, high throughput detection and identification of micro and nano-scale defects by inspection tools (such as a Scanning Electron Microscope ('SEM')) is essential for maintaining high yield and low cost.

A SEM comprises an scanning device and a detector apparatus. The scanning device comprises an illumination apparatus that comprises an electron source, for generating primary electrons, and a projection apparatus for scanning a sample, such as a substrate, with one or more focused beams of primary electrons. The primary electrons interact with the sample and generate secondary electrons. The detection apparatus captures the secondary electrons from the sample as the sample is scanned so that the SEM can create an image of the scanned area of the sample. For high throughput inspection, some of the inspection apparatuses use multiple focused beams, i.e. a multi-beam, of primary electrons. The component beams of the multi-beam may be referred to as sub-beams or beamlets. A multi-beam can scan different parts of a sample simultaneously. A multi-beam inspection apparatus can therefore inspect a sample at a much higher speed than a single-beam inspection apparatus.

In a multi-beam inspection apparatus, the paths of some of the primary electron beams are displaced away from the central axis, i.e. a mid-point of the primary electron optical axis, of the scanning device. To ensure all the electron beams arrive at the sample surface with substantially the same angle of incidence, and/or with a desired pitch and/or at a desired locations on the sample surface, sub-beam paths with a greater radial distance from the central axis need to be manipulated to move through a greater angle than the sub-beam paths with paths closer to the central axis. This stronger manipulation may cause aberrations which result in blurry and out-of-focus images of the sample substrate. In particular, for sub-beam paths that are not on the central axis, the aberrations in the sub-beams may increase with the radial displacement from the central axis because the manipulators of these sub-beam paths are required to operate at larger voltages. Such aberrations may remain associated with the secondary electrons when they are detected. Such aberrations therefore degrade the quality of images that are created during inspection.

An implementation of a known multi-beam inspection apparatus is described below.

The figures are schematic. Relative dimensions of components in drawings are therefore exaggerated for clarity. Within the following description of drawings the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons throughout the present document may therefore be more generally be considered to be references to charged particles, with the charged particles not necessarily being electrons.

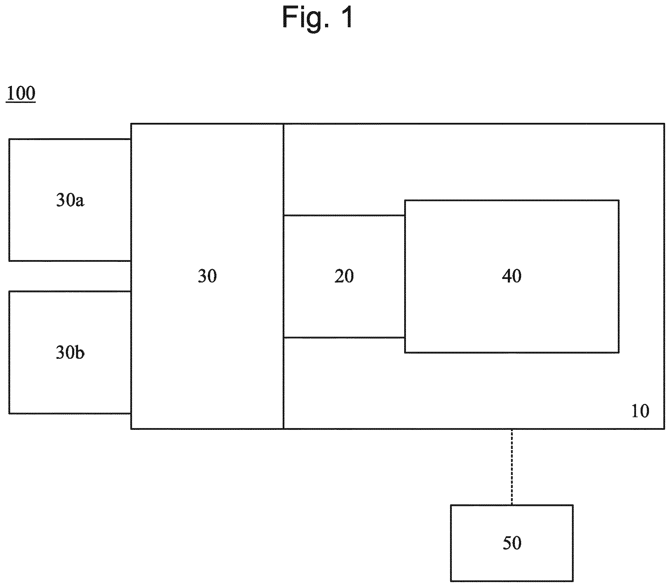

Reference is now made to **FIG. 1,** which is a schematic diagram illustrating an exemplary charged particle beam inspection apparatus 100. The charged particle beam inspection apparatus 100 of Fig. 1 includes a main chamber 10, a load lock chamber 20, an electron beam tool 40, an equipment front end module (EFEM) 30 and a controller 50. Electron beam tool 40 is located within main chamber 10.

EFEM 30 includes a first loading port 30a and a second loading port 30b. EFEM 30 may include additional loading port(s). First loading port 30a and second loading port 30b may, for example, receive substrate front opening unified pods (FOUPs) that contain substrates (e.g., semiconductor substrates or substrates made of other material(s)) or samples to be inspected (substrates, wafers and samples are collectively referred to as "samples" hereafter). One or more robot arms (not shown) in EFEM 30 transport the samples to load lock chamber 20.

Load lock chamber 20 is used to remove the gas around a sample. This creates a vacuum that is a local gas pressure lower than the pressure in the surrounding environment. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. After reaching the first pressure, one or more robot arms (not shown) transport the sample from load lock chamber 20 to main chamber 10. Main chamber 10 is connected to a main chamber vacuum pump system (not shown). The main chamber vacuum pump system removes gas particles in main chamber 10 so that the pressure in around the sample reaches a second pressure lower than the first pressure. After reaching the second pressure, the sample is transported to the electron beam tool by which it may be inspected. An electron beam tool 40 may comprise either a single beam or a multi-beam electron-optical apparatus.

Controller 50 is electronically connected to electron beam tool 40. Controller 50 may be a processor (such as a computer) configured to control the charged particle beam inspection apparatus 100. Controller 50 may also include a processing circuitry configured to execute various signal and image processing functions. While controller 50 is shown in **FIG. 1** as being outside of the structure that includes main chamber 10, load lock chamber 20, and EFEM 30, it is appreciated that controller 50 may be part of the structure. The controller 50 may be located in one of the component elements of the charged particle beam inspection apparatus or it can be distributed over at least two of the component elements. While the present disclosure provides examples of main chamber 10 housing an electron beam inspection tool, it should be noted that aspects of the disclosure in their broadest sense are not limited to a chamber housing an electron beam inspection tool. Rather, it is appreciated that the foregoing principles may also be applied to other tools and other arrangements of apparatus, that operate under the second pressure.

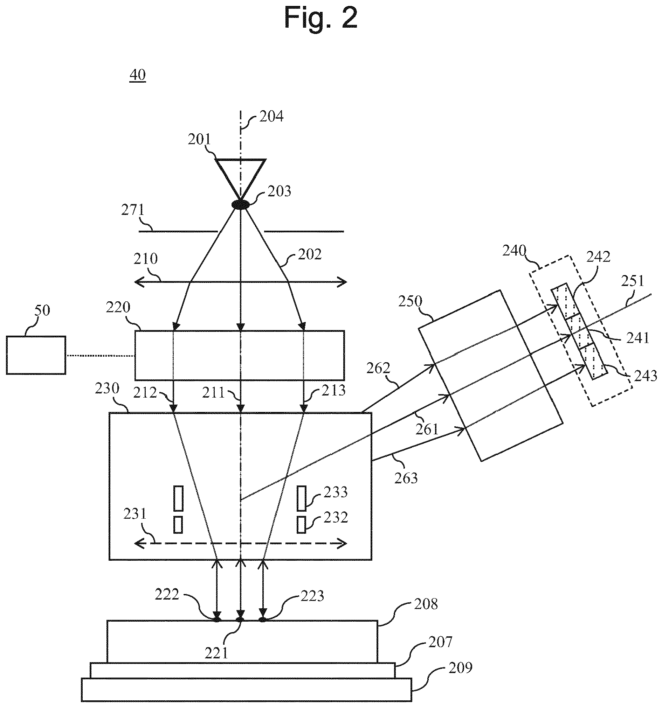

Reference is now made to **FIG. 2,** which is a schematic diagram illustrating an exemplary electron beam tool 40 including a multi-beam inspection tool that is part of the exemplary charged particle beam inspection apparatus 100 of **FIG. 1**. Multi-beam electron beam tool 40 (also referred to herein as apparatus 40) comprises an electron source 201, a gun aperture plate 271, a condenser lens 210, a source conversion unit 220, a primary projection apparatus 230, a motorized stage 209, and a sample holder 207. The electron source 201, a gun aperture plate 271, a condenser lens 210, a source conversion unit 220 are the components of an illumination apparatus comprised by the multi-beam electron beam tool 40. The sample holder 207 is supported by motorized stage 209 so as to hold a sample 208 (e.g., a substrate or a mask) for inspection. Multi-beam electron beam tool 40 may further comprise a secondary projection apparatus 250 and an associated electron detection device 240. Primary projection apparatus 230 may comprise an objective lens 231. Electron detection device 240 may comprise a plurality of detection elements 241, 242, and 243. A beam separator 233 and a deflection scanning unit 232 may be positioned inside primary projection apparatus 230.

The components that are used to generate a primary beam may be aligned with a primary electron-optical axis of the apparatus 40. These components can include: the electron source 201, gun aperture plate 271, condenser lens 210, source conversion unit 220, beam separator 233, deflection scanning unit 232, and primary projection apparatus 230. Secondary projection apparatus 250 and its associated electron detection device 240 may be aligned with a secondary electron-optical axis 251 of apparatus 40.

The primary electron-optical axis 204 is comprised by the electron-optical axis of the of the part of electron beam tool 40 that is the illumination apparatus. The secondary electron-optical axis 251 is the electron-optical axis of the of the part of electron beam tool 40 that is a detection apparatus. The primary electron-optical axis 204 may also be referred to herein as the primary optical axis (to aid ease of reference) or charged particle optical axis. The secondary electron-optical axis 251 may also be referred to herein as the secondary optical axis or the secondary charged particle optical axis.

Electron source 201 may comprise a cathode (not shown) and an extractor or anode (not shown). During operation, electron source 201 is configured to emit electrons as primary electrons from the cathode. The primary electrons are extracted or accelerated by the extractor and/or the anode to form a primary electron beam 202 that forms a primary beam crossover (virtual or real) 203. Primary electron beam 202 may be visualized as being emitted from primary beam crossover 203.

In this arrangement a primary electron beam, by the time it reaches the sample, and preferably before it reaches the projection apparatus, is a multi-beam. Such a multi-beam can be generated from the primary electron beam in a number of different ways. For example, the multi-beam may be generated by a multi-beam array located before the cross-over, a multi-beam array located in the source conversion unit 220, or a multi-beam array located at any point in between these locations. A multi-beam array may comprise a plurality of electron beam manipulating elements arranged in an array across the beam path. Each manipulating element may influence the primary electron beam to generate a sub-beam. Thus the multi-beam array interacts with an incident primary beam path to generate a multi-beam path down-beam of the multi-beam array.

Gun aperture plate 271, in operation, is configured to block off peripheral electrons of primary electron beam 202 to reduce Coulomb effect. The Coulomb effect may enlarge the size of each of probe spots 221, 222, and 223 of primary sub-beams 211, 212, 213, and therefore deteriorate inspection resolution. A gun aperture plate 271 may also be referred to as a coulomb aperture array.

Condenser lens 210 is configured to focus primary electron beam 202. Condenser lens 210 may be designed to focus primary electron beam 202 to become a parallel beam and be normally incident onto source conversion unit 220. Condenser lens 210 may be a movable condenser lens that may be configured so that the position of its first principle plane is movable. The movable condenser lens may be configured to be magnetic. Condenser lens 210 may be an anti-rotation condenser lens and/or it may be movable.

Source conversion unit 220 may comprise an image-forming element array, an aberration compensator array, a beam-limit aperture array, and a pre-bending micro-deflector array. The pre-bending micro-deflector array may deflect a plurality of primary sub-beams 211, 212, 213 of primary electron beam 202 to normally enter the beam-limit aperture array, the image-forming element array, and an aberration compensator array. In this arrangement, the image-forming element array may function as a multi-beam array to generate the plurality of sub-beams in the multi-beam path, i.e. primary sub-beams 211, 212, 213. The image forming array may comprise a plurality electron beam manipulators such as micro-deflectors micro-lenses (or a combination of both) to influence the plurality of primary sub-beams 211, 212, 213 of primary electron beam 202 and to form a plurality of parallel images (virtual or real) of primary beam crossover 203, one for each of the primary sub-beams 211, 212, and 213. The aberration compensator array may comprise a field curvature compensator array (not shown) and an astigmatism compensator array (not shown). The field curvature compensator array may comprise a plurality of micro-lenses to compensate field curvature aberrations of the primary sub-beams 211, 212, and 213. The astigmatism compensator array may comprise a plurality of micro-stigmators to compensate astigmatism aberrations of the primary sub-beams 211, 212, and 213. The beam-limit aperture array may be configured to limit diameters of individual primary sub-beams 211, 212, and 213. **FIG. 2** shows three primary sub-beams 211, 212, and 213 as an example, and it should be understood that source conversion unit 220 may be configured to form any number of primary sub-beams. Controller 50 may be connected to various parts of charged particle beam inspection apparatus 100 of **FIG. 1,** such as source conversion unit 220, electron detection device 240, primary projection apparatus 230, or motorized stage 209. As explained in further detail below, controller 50 may perform various image and signal processing functions. Controller 50 may also generate various control signals to govern operations of the charged particle beam inspection apparatus, including the charged particle multi-beam apparatus.

Condenser lens 210 may further be configured to adjust electric currents of primary sub-beams 211, 212, 213 down-beam of source conversion unit 220 by varying the focusing power of condenser lens 210. Alternatively, or additionally, the electric currents of the primary sub-beams 211, 212, 213 may be changed by altering the radial sizes of beam-limit apertures within the beam-limit aperture array corresponding to the individual primary sub-beams. The electric currents may be changed by both altering the radial sizes of beam-limit apertures and the focusing power of condenser lens 210. If the condenser lens is moveable and magnetic, off-axis sub-beams 212 and 213 may result that illuminate source conversion unit 220 with rotation angles. The rotation angles change with the focusing power or the position of the first principal plane of the movable condenser lens. A condenser lens 210 that is an anti-rotation condenser lens may be configured to keep the rotation angles unchanged while the focusing power of condenser lens 210 is changed. Such a condenser lens 210 that is also movable, may cause the rotation angles not change when the focusing power of the condenser lens 210 and the position of its first principal plane are varied.

Objective lens 231 may be configured to focus sub-beams 211, 212, and 213 onto a sample 208 for inspection and may form three probe spots 221, 222, and 223 on the surface of sample 208.

Beam separator 233 may be, for example, a Wien filter comprising an electrostatic deflector generating an electrostatic dipole field and a magnetic dipole field (not shown in **FIG. 2**). In operation, beam separator 233 may be configured to exert an electrostatic force by electrostatic dipole field on individual electrons of primary sub-beams 211, 212, and 213. The electrostatic force is equal in magnitude but opposite in direction to the magnetic force exerted by magnetic dipole field of beam separator 233 on the individual electrons. Primary sub-beams 211, 212, and 213 may therefore pass at least substantially straight through beam separator 233 with at least substantially zero deflection angles.

Deflection scanning unit 232, in operation, is configured to deflect primary sub-beams 211, 212, and 213 to scan probe spots 221, 222, and 223 across individual scanning areas in a section of the surface of sample 208. In response to incidence of primary sub-beams 211, 212, and 213 or probe spots 221, 222, and 223 on sample 208, electrons are generated from the sample 208 which include secondary electrons and backscattered electrons. The secondary electrons propagate in three secondary electron beams 261, 262, and 263. The secondary electron beams 261, 262, and 263 typically have secondary electrons (having electron energy < 50eV) and may also have at least some of the backscattered electrons (having electron energy between 50eV and the landing energy of primary sub-beams 211, 212, and 213). The beam separator 233 is arranged to deflect the path of the secondary electron beams 261, 262, and 263 towards the secondary projection apparatus 250. The secondary projection apparatus 250 subsequently focuses the path of secondary electron beams 261, 262, and 263 onto a plurality of detection regions 241, 242, and 243 of electron detection device 240. The detection regions may be the separate detection elements 241, 242, and 243 that are arranged to detect corresponding secondary electron beams 261, 262, and 263. The detection regions generate corresponding signals which are sent to controller 50 or a signal processing system (not shown), e.g. to construct images of the corresponding scanned areas of sample 208.

The detection elements 241, 242, and 243 may detect the corresponding secondary electron beams 261, 262, and 263. On incidence of secondary electron beams with the detection elements 241, 242 and 243, the elements may generate corresponding intensity signal outputs (not shown). The outputs may be directed to an image processing system (e.g., controller 50). Each detection element 241, 242, and 243 may comprise one or more pixels. The intensity signal output of a detection element may be a sum of signals generated by all the pixels within the detection element.

The controller 50 may comprise image processing system that includes an image acquirer (not shown) and a storage device (not shown). For example, the controller may comprise a processor, computer, server, mainframe host, terminals, personal computer, any kind of mobile computing devices, and the like, or a combination thereof. The image acquirer may comprise at least part of the processing function of the controller. Thus the image acquirer may comprise at least one or more processors. The image acquirer may be communicatively coupled to an electron detection device 240 of the apparatus 40 permitting signal communication, such as an electrical conductor, optical fiber cable, portable storage media, IR, Bluetooth, internet, wireless network, wireless radio, among others, or a combination thereof. The image acquirer may receive a signal from electron detection device 240, may process the data comprised in the signal and may construct an image therefrom. The image acquirer may thus acquire images of sample 208. The image acquirer may also perform various post-processing functions, such as generating contours, superimposing indicators on an acquired image, and the like. The image acquirer may be configured to perform adjustments of brightness and contrast, etc. of acquired images. The storage may be a storage medium such as a hard disk, flash drive, cloud storage, random access memory (RAM), other types of computer readable memory, and the like. The storage may be coupled with the image acquirer and may be used for saving scanned raw image data as original images, and post-processed images.

The image acquirer may acquire one or more images of a sample based on an imaging signal received from the electron detection device 240. An imaging signal may correspond to a scanning operation for conducting charged particle imaging. An acquired image may be a single image comprising a plurality of imaging areas. The single image may be stored in the storage. The single image may be an original image that may be divided into a plurality of regions. Each of the regions may comprise one imaging area containing a feature of sample 208. The acquired images may comprise multiple images of a single imaging area of sample 208 sampled multiple times over a time period. The multiple images may be stored in the storage. The controller 50 may be configured to perform image processing steps with the multiple images of the same location of sample 208.

The controller 50 may include measurement circuitry (e.g., analog-to-digital converters) to obtain a distribution of the detected secondary electrons. The electron distribution data, collected during a detection time window, can be used in combination with corresponding scan path data of each of primary sub-beams 211, 212, and 213 incident on the sample surface, to reconstruct images of the sample structures under inspection. The reconstructed images can be used to reveal various features of the internal or external structures of sample 208. The reconstructed images can thereby be used to reveal any defects that may exist in the sample.

The controller 50 may control motorized stage 209 to move sample 208 during inspection of sample 208. The controller 50 may enable motorized stage 209 to move sample 208 in a direction, preferably continuously, for example at a constant speed, at least during sample inspection. The controller 50 may control movement of the motorized stage 209 so that it changes the speed of the movement of the sample 208 dependent on various parameters. For example, the controller may control the stage speed (including its direction) depending on the characteristics of the inspection steps of scanning process.

Although **FIG. 2** shows that apparatus 40 uses three primary electron sub-beams, it is appreciated that apparatus 40 may use two or more number of primary electron sub-beams. The present disclosure does not limit the number of primary electron beams used in apparatus 40.

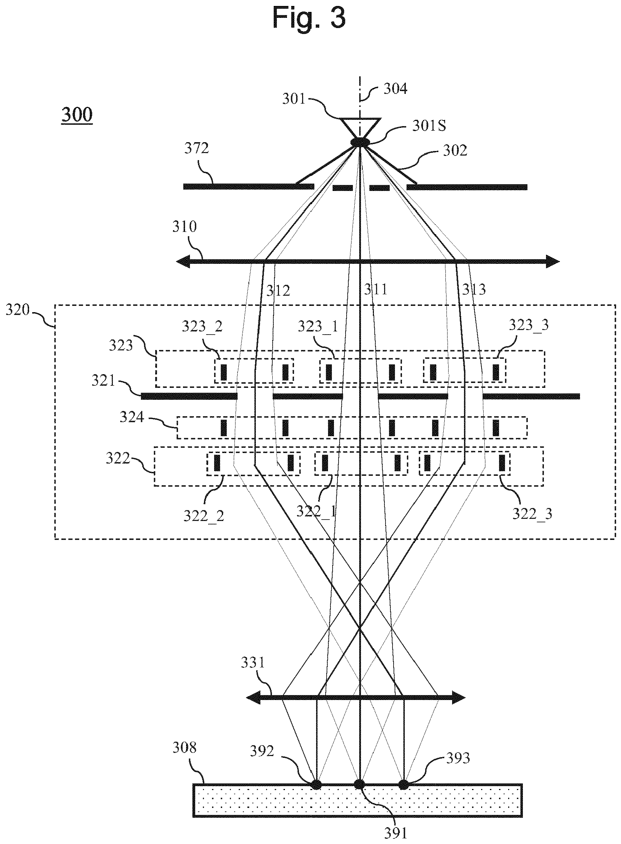

Reference is now made to **FIG. 3,** which is a schematic diagram of exemplary multi-beam apparatus illustrating an exemplary configuration of source conversion unit of the exemplary charged particle beam inspection apparatus of **FIG. 1.** The apparatus 300 may comprise an election source 301, a pre-sub-beam-forming aperture array 372, a condenser lens 310 (similar to condenser lens 210 of **FIG. 2**), a source conversion unit 320, an objective lens 331 (similar to objective lens 231 of **FIG. 2**), and a sample 308 (similar to sample 208 of **FIG. 2**). The election source 301, a pre-sub-beam-forming aperture array 372, a condenser lens 310 may be the components of an illumination apparatus comprised by the apparatus 300. The source conversion unit 320, an objective lens 331 may the components of a projection apparatus comprised by the apparatus 300. The source conversion unit 320 may be similar to source conversion unit 220 of **FIG. 2** in which the image-forming element array of **FIG. 2** is image-forming element array 322, the aberration compensator array of **FIG. 2** is aberration compensator array 324, the beam-limit aperture array of **FIG. 2** is beam-limit aperture array 321, and the pre-bending micro-deflector array of **FIG. 2** is pre-bending micro-deflector array 323. The election source 301, the pre-sub-beam-forming aperture array 372, the condenser lens 310, the source conversion unit 320, and the objective lens 331 are aligned with a primary electron-optical axis 304 of the apparatus. The electron source 301 generates a primary-electron beam 302 generally along the primary electron-optical axis 304 and with a source crossover (virtual or real) 301S. The pre-sub-beam-forming aperture array 372 cuts the peripheral electrons of primary electron beam 302 to reduce a consequential Coulomb effect. The Coulomb effect is a source of aberration to the sub-beams due to interaction between electrons in different sub-beam paths. Primary-electron beam 302 may be trimmed into a specified number of sub-beams, such as three sub-beams 311, 312 and 313, by pre-sub-beam-forming aperture array 372 of a pre-sub-beam-forming mechanism. Although three sub-beams and their paths are referred to in the previous and following description, it should be understood that the description is intended to apply an apparatus, tool, or system with any number of sub-beams.

The source conversion unit 320 may include a beamlet-limit aperture array 321 with beam-limit apertures configured to limit the sub-beams 311, 312, and 313 of the primary electron beam 302. The source conversion unit 320 may also include an image-forming element array 322 with image-forming micro-deflectors, 322_1, 322_2, and 322_3. There is a respective micro-deflector associated with the path of each sub-beam. The micro-deflectors 322_1, 322_2, and 322_3 are configured to deflect the paths of the sub-beams 311, 312, and 313 towards the electron-optical axis 304. The deflected sub-beams 311, 312 and 313 form virtual images of source crossover 301S. The virtual images are projected onto the sample 308 by the objective lens 331 and form probe spots thereon, which are the three probe spots, 391, 392, and 393. Each probe spot corresponds to the location of incidence of a sub-beam path on the sample surface. The source conversion unit 320 may further comprise an aberration compensator array 324 configured to compensate aberrations of each of the sub-beams. The aberrations in each sub-beam are typically present on the probe spots, 391, 392, and 393 that would be formed a sample surface. The aberration compensator array 324 may include a field curvature compensator array (not shown) with micro-lenses. The field curvature compensator and micro-lenses are configured to compensate the sub-beams for field curvature aberrations evident in the probe spots, 391, 392, and 393. The aberration compensator array 324 may include an astigmatism compensator array (not shown) with micro-stigmators. The micro-stigmators are controlled to operate on the sub-beams to compensate astigmatism aberrations that are otherwise present in the probe spots, 391, 392, and 393.

The source conversion unit 320 may further comprise a pre-bending micro-deflector array 323 with pre-bending micro-deflectors 323_1, 323_2, and 323_3 to bend the sub-beams 311, 312, and 313 respectively. The pre-bending micro-deflectors 323_1, 323_2, and 323_3 may bend the path of the sub-beams onto the beamlet-limit aperture array 321. The sub-beam path of the incident on beamlet-limit aperture array 321 may be orthogonal to the plane of orientation of the beamlet-limit aperture array 321. The condenser lens 310 may direct the path of the sub-beams onto the beamlet-limit aperture array 321. The condenser lens 310 may focus the three sub-beams 311, 312, and 313 to become parallel beams along primary electron-optical axis 304, so that it is perpendicularly incident onto source conversion unit 320, which may correspond to the beamlet-limit aperture array 321.

The image-forming element array 322, the aberration compensator array 324, and the pre-bending micro-deflector array 323 may comprise multiple layers of sub-beam manipulating devices, some of which may be in the form or arrays, for example: micro-deflectors, micro-lenses, or micro-stigmators.

In source the conversion unit 320, the sub-beams 311, 312 and 313 of the primary electron beam 302 are respectively deflected by the micro-deflectors 322_1, 322_2 and 322_3 of image-forming element array 322 towards the primary electron-optical axis 304. It should be understood that the sub-beam 311 path may already correspond to the electron-optical axis 304 prior to reaching micro-deflector 322_1, accordingly the sub-beam 311 path may not be deflected by micro-deflector 322_1.

The objective lens 331 focuses the sub-beams onto the surface of the sample 308, i.e., it projects the three virtual images onto the sample surface. The three images formed by three sub-beams 311 to 313 on the sample surface form three probe spots 391, 392 and 393 thereon. The deflection angles of sub-beams 311 to 313 are adjusted by the objective lens 311 to reduce the off-axis aberrations of three probe spots 391-393. The three deflected sub-beams consequently pass through or approach the front focal point of objective lens 331.

At least some of the above-described components in **FIG. 2** and **FIG. 3** may individually, or in combination with each other, be referred to as a manipulator array, or manipulator, because they manipulate one or more beams, or sub-beams, of charged particles.

The above described multi-beam inspection tool comprises a multi-beam charged particle apparatus, that may be referred to as a multi-beam charged particle optical apparatus or a multi-beam charged particle system, with a single source of charged particles. The multi-beam charged particle apparatus comprises an illumination apparatus and a projection apparatus. The illumination apparatus may generate a multi-beam of charged particles from the beam of electrons from the source. The projection apparatus projects a multi-beam of charged particles towards a sample. At least part of the surface of a sample is scanned with the multi-beam of charged particles.

A number of problems may be experienced by the above-described multi-beam charged particle apparatus that complicate applying simultaneous manipulations to the sub-beams of the multi-beam.

In order for each of the individual sub-beam paths to be appropriately directed towards the sample surface, individual components may be provided, in for example a manipulator array, for separately manipulating the path of each sub-beam. The applied manipulation may be, for example, a deflection of the path of a sub-beam. The manipulator array may be, for example, the manipulator array as described with reference to Figures 2 to 4 and 6 of EP 2715768A2.

A requirement that should be met in order for an individual component to be able to appropriately apply a manipulation to a sub-beam is that the aberrations caused by the manipulation are not excessive. The extent of aberrations are dependent on the uniformity of the electric field within the manipulating component, the fill factor of the manipulating component and the magnitude of the electric field within the manipulating component. The magnitude of the electric field is dependent on the voltages applied to electrodes within the manipulating component.

The extent of the aberrations is dependent on the uniformity of the electric field that a sub-beam path travels through. An ideal electric field across the component would be linear. However, in plan view, the opening is circular and a linear electric field can only be approximated by providing a plurality of electrodes around the opening and appropriately applied voltages at each electrode. The quality of the approximation of a linear field that can be achieved increases as the number of electrodes that are used is increased. However, increasing the number of electrodes within a component increases its size. Increasing the number of electrodes also increases the complexity of providing wiring to all of the electrodes of each of the components and the associated driver circuitry.

The fill factor is the ratio of the diameter of a sub-beam within a manipulating component to the diameter of the opening within the manipulating component. In plan view, the most uniform electric field within the component is in the middle of the opening with the electric field being least uniform towards the edges of the opening. The extent of aberrations increases as the fill factor increases because the proportion of the sub-beam that is away from the middle of the opening increases. For a particular sub-beam diameter, the fill factor can be decreased by increasing the diameter of the opening of the component.

The extent of the aberrations is also dependent on the magnitude of the voltages applied within a component to generate an electric field. At larger voltages, the non-uniformities in the electric field have a greater effect on a sub-beam path and this increases aberrations.

Due to at least the above-described requirements of a low fill factor and/or having a large number of electrodes, it is necessary for each individual component to be relatively large and the wiring and driver circuitry requirements are complicated. When relatively large individual components are required for manipulating each sub-beam, the space restraints within the charged particle apparatus impose restrictions on both the number of sub-beams that can be provided and the density of the sub-beams.

Furthermore, in order for relatively large deflections to be applied to some of the sub-beam paths, relatively large voltages are required for generating electric fields. However, as explained above, the use of relatively large voltages increases the extent of aberrations.

Embodiments provide a manipulator device for simultaneously applying substantially constant deflections to some, or all, of the paths of a plurality of sub-beams in a multi-beam.

The manipulator device according to embodiments may reduce at least some of the manipulation requirements, in particular deflection requirements, of a manipulator array that comprises individual components for each sub-beam. The manipulator device according to embodiments may provide the main deflection of all of the sub-beam paths that are deflected. This both reduces the complexity of providing a manipulator array and improves the control of sub-beam paths within the charged particle apparatus. The manipulator device according to embodiments may apply substantially constant deflections to lines of sub-beams and does not require complicated control circuitry.

When a manipulator device according to embodiments is used, the manipulator array is only required to apply fine deflections to the individual sub-beam paths. The components within the individual array are not required to apply large deflections and so a simpler component design may be used within which only relatively small voltages need to be applied. A simpler component design may comprise fewer electrodes and thereby reduce the complexity of the wiring and driver requirements for each of the components. The use of low voltages reduces the extent of aberrations compared to when larger voltages are used. This allows smaller individual components for each sub-beam to be used because, for a particular extent of aberrations, both the fill factor of the components may be increased and the number of electrodes reduced. The use of smaller individual components in a manipulator array increases the density of the sub-beams and/or the number of sub-beams that may be supported.

The manipulator device according to embodiments is particularly appropriate for providing a passive electron-optical manipulating device such as a pre-bend manipulation of paths of charged particles within a charged particle apparatus. A pre-bend manipulation may comprise applied deflections that are substantially invariant across the range of operating conditions. A pre-bend may cause the paths of the charged particle beams to converge. Another passive element is a collimator which collimates the paths of charged particle beams. A collimated multi-beam may be generated from sub-beam paths that are either convergent or divergent.

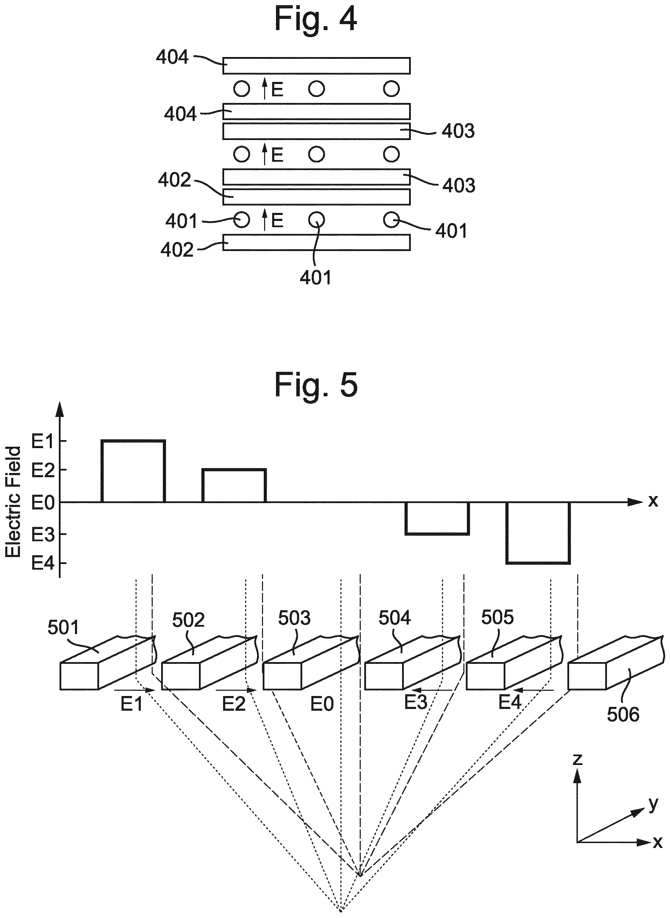

FIG. 4 is a schematic diagram of a manipulator device according to an embodiment. FIG. 4 is a plan view of a multi-beam, which may be along the charged particle axis. The manipulator device comprises a first pair of electrodes 402, a second pair of electrodes 403, and a third pair of electrodes 404. Between each of these pairs of parallel planar electrodes are the paths of a different line of three sub-beams 401 of the multi-beam. Each pair of parallel planar electrodes may be referred to as strip electrodes.

Each electrode may be a planar plate. Each electrode may be metallic, such as a metal plate or metalized or metal coated surface. Each electrode may each be, for example, a metal coating on the surface of a supporting structure, or body, of the electrode. Each pair of electrodes may comprise two such planar plates arranged in parallel with, and facing, each other. An electric field, E, is applied between each pair of electrodes. For each pair of electrodes, the electric field is applied in a direction that is both orthogonal to the surface of the electrode, i.e. the planar plate, and also substantially orthogonal to the path of each sub-beam between the pair of electrodes. Each pair of electrodes can thereby electrostatically interact with the plurality of sub-beams that pass between them and can thereby deflect the paths of the sub-beams.

The multi-beam of charged particles comprises a plurality of lines of sub-beams. Thus the multi-beam is a two-dimensional array of sub-beams, which may be a series of the plurality of lines of the sub-beams. Each pair of electrodes is arranged to deflect the paths of all of the sub-beams in an entire line of sub-beams.

The deflection amount to the paths of each line of sub-beams that is applied by each pair of electrodes is dependent on the potential difference between the electrodes. Thus the magnitude of deflection of a line of paths of charged particle beams may be determined by the size of the potential difference applied between the parallel plates either side of the line of beam paths. So a relatively large deflection can be achieved by applying a larger potential difference between the opposing electrode surfaces.

The potential difference between each pair of electrodes may be individually and separately controllable. This allows each of the pairs of electrodes to apply different deflection amounts to the paths of a line of the sub-beams. Thus the applied deflection amount across the array is settable and actively controllable. In addition, the direction of the applied electric field may differ between the pairs of electrodes. This allows the deflection amounts to the paths of lines of sub-beams to be applied in opposite directions.

In an embodiment, during operation one or more pairs of electrodes in the manipulator array may be set to have zero potential difference between them. Thus, although each pair of electrodes may deflect the paths of sub-beams in a line of sub-beams, one or more of the pairs of electrodes may be operated so that an electric field is not applied between the electrodes. Such an electrode pair would not deflect the paths of the sub-beams that travel between them.

FIG. 5 is a schematic diagram of a manipulator device according to an embodiment. FIG. 5 shows five separate lines of sub-beam paths. For each line, two of the sub-beam paths in the line are shown. For each line of sub-beams, there is a respective pair electrodes that the line of sub-beams travels between. The electrodes are supported by the electrode supports 501, 502, 503, 504, 505 and 506. Each of the electrode supports may be made of, for example, glass or the material of the substrate from which the electrodes are made, e.g. silicon. The potential difference between each pair of electrodes may differ in magnitude and/or direction. Embodiments include there being no potential difference between one or more of the pairs of electrodes. An example as shown in the figure is between the middle pair of electrodes (see E0). The applied potential differences between the pairs of electrodes is shown in FIG. 5 as E1, E2, E3 and E4. The magnitude of the electric field E1 is larger than that of E2 which in turn would be larger than E0. Likewise, E4 is larger in electric filed magnitude than E3 which in turn is larger than E0. E3 and E4 have fields which appear to oppose in direction each of E1 and E2. Indeed E1 and E4 may have similar or indeed the same magnitude of electric field but opposite direction; and E3 and E4 may have similar or the same magnitude but with opposite direction. In an alternative arrangement, a potential difference may be applied across the middle pair of electrodes so that E0 is not zero.

As shown in **FIG. 5,** the effect of the applied potential differences may be to generate a down-beam cross-over point for the paths of separate lines of sub-beams. No potential difference, i.e. E0, is applied between the pair of electrodes that the middle line of sub-beams travels through. The path of the middle line of sub-beams is therefore not substantially deflected by a pair of electrodes. The potential difference E1 applied between the pair of electrodes that the leftmost line of sub-beams in the figure travels through may have the same magnitude, and opposite sign, to the potential difference E4 applied between the pair of electrodes that the rightmost line of sub-beams travels through. The potential difference E2 applied between the pair of electrodes that the second leftmost line of sub-beams travels through may have the same magnitude, and opposite sign, to the potential difference E3 applied between the pair of electrodes that the second rightmost line of sub-beams travels through. The magnitudes of the potential differences E1 and E4 may be larger than the potential differences E2 and E3 such that the paths of the leftmost and rightmost lines of sub-beams are deflected more than the paths of the second leftmost and second rightmost lines of sub-beams.

The path of the first sub-beam in each line of sub-beams down-beam from the manipulator may intersect the paths of the first sub-beams in the other lines of sub-beams at substantially the same first down beam position. The path of the second sub-beam in each line of sub-beams may intersect the paths of the other second sub-beams in the other lines of sub-beams at substantially the same second down beam position. The first down beam position may be different from the second down beam position.

Although **FIG. 5** shows two sub-beams in each line of sub-beams, embodiments include there being any number of sub-beams in each line of sub-beams.

Although **FIG. 5** shows five separate lines of sub-beams, embodiments include there being any number of lines of sub-beams, as well as a respective pair electrodes for each line of sub-beams.

Embodiments also include the potential differences applied to one or more of the pairs of electrodes causing the paths of two or more of the lines of sub-beams to diverge instead of converge.

In **FIG. 5,** parallel structures that the lines of sub-beams pass between are shown schematically. It should be understood that these parallel structures represent both electrodes that the lines of sub-beams travel between and also the support structure for the electrodes. The specific arrangement of how electrodes are supported by a support structure may be by a number of different techniques.

As shown in **FIG. 4** and **FIG. 5,** sub-beams only travel between adjacent electrodes in an pair of electrodes for deflecting sub-beam paths. Sub-beams do not travel between adjacent electrodes when each of the electrodes is in a different pair of electrodes for deflecting sub-beam paths. For adjacent electrodes with each of the electrodes being in a different pair of electrodes, the adjacent electrodes may be supported by a solid support structure, such as a substrate, as shown in **FIG. 5.** Alternatively, the adjacent electrodes may be separated by a gap as shown in **FIG. 4.**

Between each of the adjacent electrodes, a high voltage shield may be provided in the support structure of the electrodes for electrically isolating the ends of the electrodes that contact the support structure from each other.

Embodiments also include there being more than one set of pairs of electrodes for deflecting the paths of lines of sub-beams. Each of the sets of pairs of electrodes may be a set of pairs of parallel plate electrodes as described above with reference to **FIGS. 4 and 5.** Each of the sets of pairs of electrodes may be provided at a different positions along the charged particle axis, i.e. the path of the multi- beam.

Within each of the sets of pairs of electrodes (or an array of electrode pairs), and for the pairs of electrodes in which there is an applied electric field, all of the applied electric fields may be aligned orthogonally to the same axis for the set of pairs of electrodes. Although the applied potential differences between the pairs of electrodes may result in some of the applied electric fields being in opposite directions to each other, the applied electric fields are still aligned orthogonally to the same axis. The pairs of parallel electrodes in each set are aligned parallel to the axis of the set. As shown in **FIG. 5,** the potential difference applied between facing pairs of parallel plates may depend on the distance from the midpoint of the array. For example the electric field may be proportional to the distance from the midpoint of the array of parallel plates. Accordingly, the applied deflections may direct the beam paths down beam of the manipulator array to a point at which the lines of paths cross with the beam paths at each respective line position crossing with each other.

Embodiments include there being a plurality of sets of pairs of electrodes arranged in series along the multi-beam path. The axes of two or more of the sets may be aligned in different directions. The axes of all of the sets may be aligned in different directions. When the axes of two or more of the sets are aligned in different directions, the differently aligned sets will apply differently directed deflections to paths of sub-beams in the multi-beam. Having more than one set of pairs of electrodes therefore increases the amount of control that can be applied to the paths of the sub-beams.

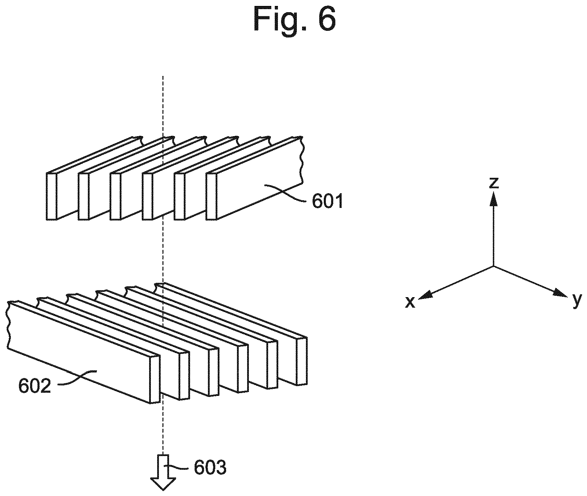

As shown in **FIG. 6,** there may be a first set, or array, of pairs of electrodes 601 and a second set, or array, of pairs of electrodes 602. These two arrays may have their pairs of parallel plates aligned orthogonal with each other and also with the multi-beam path. The first and second sets of pairs of electrodes are provided at a different positions along the path 603 of the multi-beam. The axes of each of the first and second sets of pairs of electrodes are aligned in different directions. Although **FIG. 6** shows two sets of electrodes, embodiments include there being any number of sets of electrodes.

Although the arrays of electrodes are described as being orthogonal to each other (in plane orthogonal), they may have any relative angle with respect to each other, so long as such axes represent the axes used by the invention at that time of discussion or the axes known when scheduling the discussion.

Embodiments include a number of different arrangements of sets of pairs of electrodes, as required for each set of pairs of electrodes to be able to deflect different arrangements of lines of sub-beams.

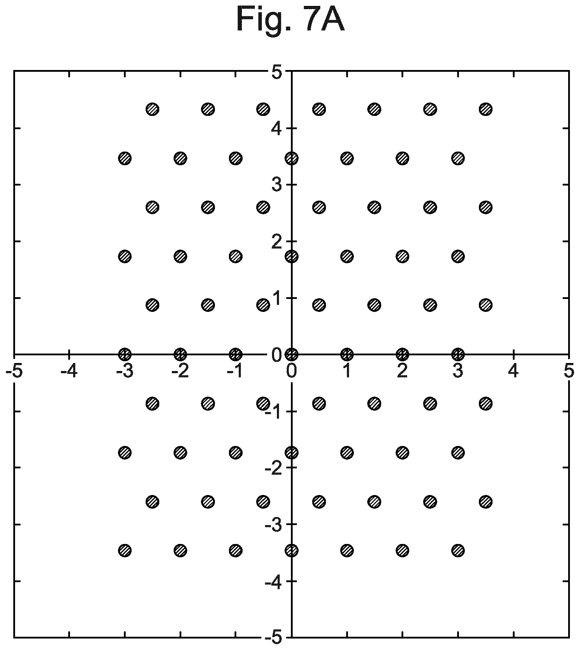

**FIG. 7A** is a schematic plan view (i.e. along the charged particle optical axis) of sub-beams in an arrangement of lines of sub-beams. The shown arrangement of sub-beams may be referred to as a hexagonal arrangement because substantially all of the sub-beams are positioned at the vertices of a plurality of hexagonal rings. The arrangement of the beams may comply with the a hexagonal close packed arrangement, which may be a desired regular form of a two dimensional array. The sub-beams are arranged in a plurality of different lines. Relative to the horizontal and vertical axes shown in **FIG. 7A,** all of the sub-beams are aligned in both lines that are parallel to the horizontal axis and lines that are parallel to the vertical axis. The sub-beams are also aligned in lines that are diagonal to the horizontal axis and the vertical axis. In a variation, the array may be optimized for scanning configuration by having the beam arrangement adjusted by an off-set, shift or skew of the beam arrangement, for example to prevent overlap of sub-beam paths.

All of the sub-beams in the multi-beam arrangement may therefore be deflected by a set of pairs of electrodes with an axis that is aligned with an axis of the pattern of the multi-beam arrangement. For the arrangement shown in Figure 7A, the axes are horizontal, vertical and along either one of the diagonals to the horizontal and vertical axes.

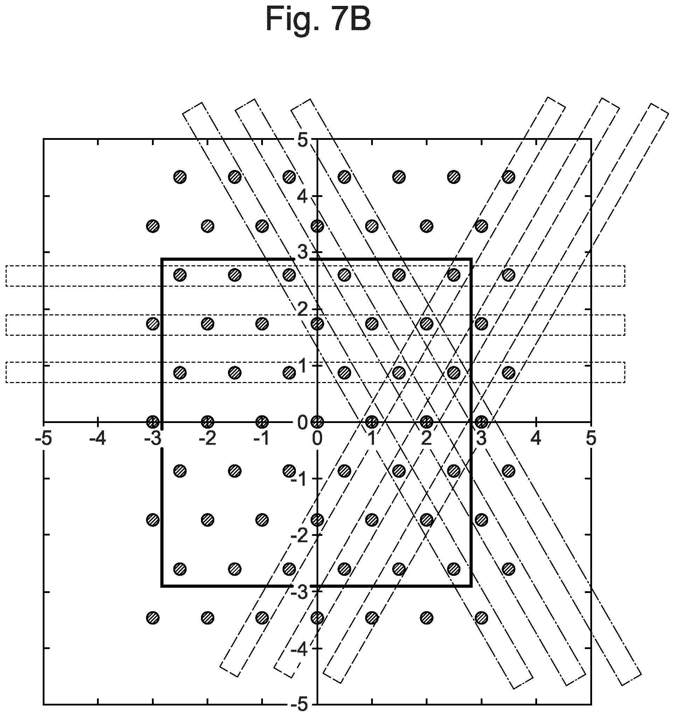

**FIG. 7B** shows how a plurality of sets of pairs of electrodes may be aligned according to an embodiment having a hexagonal beam arrangement. Each array of pairs of electrodes is at a different position along the path of the multi-beam. That is the arrays of pairs of electrodes may be arranged sequentially along the multi-beam path. As shown in **FIG. 7B,** there may be first, second and third sets of pairs of electrodes. The axis of the first set may be aligned parallel to the horizontal axis, the axis of the second set may be aligned along one of the diagonals and the axis of the third set may be aligned along the other one of the diagonals. When three sets of pairs of electrodes are used with such alignments, the pitch, i.e. spacing, between different pairs of electrodes within each set may be lower than the pitch required when only two orthogonally aligned sets of pairs of electrodes are used. As shown in **FIG. 7B,** the pairs of electrodes within each set may also be slightly misaligned with respect to each other. That is to say, each pair of electrodes within a set is aligned in the same direction and has the same length each other. However, the ends of each pair of electrodes are not aligned with each other in a direction orthogonal to the direction that each pair of electrodes within the set is aligned in.

The use of a plurality of differently aligned sets of pairs of electrodes allows improved control over the directions of the paths of the sub-beams of the multi-beam. Further, it permits the arrays of electrode pairs to be readily integrated into an electron-optical architecture designed for a hexagonal beam arrangement.

It should be noted that a deflection of charged particle beam without a counter deflection may induce an aberration in the deflected charged particle beam. In this arrangement sub-beams further from the electron-optical axis are deflected more and so exhibit may a larger aberration. Thus after a manipulator of a plurality of arrays of parallel plates brings the charged particle sub-beams to a focus, such a multi-beam may comprise aberrations. These aberrations may be corrected for by arranging for the sub-beams manipulated by one or more stigmators arranged in the path of the multi-beam.

Embodiments also include other arrangements of sub-beams in a multi-beam. When viewed along the charged particle optical axis, the positions of the sub-beams within the multi-beam may substantially correspond to the vertices of a substantially square grid, a substantially rhombic grid, a substantially skewed square grid, a substantially shifted square grid, a substantially squashed square grid, a substantially offset square grid, a substantially hexagonal grid, a substantially shifted hexagonal grid, a substantially squashed hexagonal grid, a substantially offset hexagonal grid and/or a substantially skewed hexagonal grid. The arrangement of pairs of planar electrode surfaces in each manipulator device may be determined in dependence on the arrangement of sub-beams in a multi-beam such that each pair of electrodes is arranged to deflect a line of sub-beams.

In particular, when the positions of the sub-beams within the multi-beam correspond to the vertices of a substantially square grid, two sets of pairs of electrodes may be provided. These may be a first set of pairs of electrodes 601 and a second set of pairs of electrodes 602. The first and second pairs of electrodes may be aligned in orthogonal directions so that all of the sub-beam paths may be deflected towards the charged particle optical axis and a single crossover location. When the positions of the sub-beams within the multi-beam alternatively correspond to the vertices of a substantially hexagonal grid, three sets of pairs of electrodes may be provided. These may be aligned in different directions, with the angular spacing between all of adjacent alignments being the same, so that all of the sub-beam paths may be deflected towards the charged particle optical axis and a single crossover location. In such arrangements, the multi-beam manipulator may have a number of arrays of parallel plates arranged in series, each array corresponding and aligned to a different axis of the beam arrangement of the multi-beam.

Embodiments also include the positions of the sub-beams within the multi-beam corresponding to the vertices of a substantially hexagonal grid, but only two orthogonally aligned sets pairs of electrodes provided. Within **FIG. 7B** is a square that indicates a sub-set of the sub-beams. It is apparent from the sides of the square that, despite the underlying hexagonal pattern of the sub-beams, the sub-beams are still linearly aligned in orthogonal directions, which are horizontal and vertical lines in the representation shown in **FIG. 7B.** For example, based on the representation shown in **FIG. 7B,** all of the horizontal lines of sub-beams may be deflected by a first set of pairs of electrodes and all of the vertical lines of sub-beams may be deflected by a second set of pairs of electrodes. It should be noted that within the first set of pairs of electrodes, the pitch, i.e. spacing, between adjacent electrodes arranged to deflect different lines of sub-beams is larger than the corresponding pitch within the second set of pairs of electrodes. When the positions of the sub-beams correspond to a regular hexagonal grid, the proportional difference in pitch may be $\left(\frac{(\sqrt{3})}{2}\right)$. However, embodiments include reducing, and/or increasing, this pitch difference by using sub-beams that are arranged in a substantially offset, shifted, skewed and/or squashed hexagonal grid.

Embodiments therefore provide one or more multi-beam manipulator devices for deflecting the paths of a plurality of sub-beams in a multi-beam of charged particles. The main deflections to the paths of sub-beams can be applied by each multi-beam manipulator device. The sub-beams are arranged in an array in which the sub-beams are arranged in a plurality of lines. Each multi-beam manipulator device comprises a set of electrodes that comprises a plurality of pairs of parallel planar electrode surfaces. Each pair of electrodes comprises a first planar electrode surface that is arranged along a side of one of the lines of sub-beams and a second planar electrode surface that is arranged parallel to the first planar electrode surface and along an opposite side of said one of the lines of sub-beams. Each pair of parallel planar electrode surfaces is configured to electro-statically interact with an entire line of sub-beams in the multi-beam so that it is capable of applying a deflection amount to the paths of the sub-beams. Within the set of set of electrodes, all of the pairs of electrodes may deflect the paths of sub-beams in the multi-beam in the same direction. Alternatively, one or more pairs of electrodes may deflect the paths of sub-beams in an opposite direction to one or more other pairs of electrodes. One or more pairs of electrodes within the set may not apply any deflection to the paths of sub-beams.

The pairs of electrodes within each multi-beam manipulator device may be arranged to apply different deflection amounts to sub-beams.

All of the pairs of electrodes within each multi-beam manipulator device may be configured to electro-statically interact with an entire line of sub-beams in the multi-beam to thereby apply a deflection to the paths of sub-beams. Alternatively, one or more, but not all, of the pairs of electrodes within each multi-beam manipulator device may be configured to electro-statically interact with an entire line of sub-beams in the multi-beam to thereby apply a deflection to the paths of sub-beams.

The lines of sub-beams within a multi-beam may all be parallel with each other and all of the pairs of electrodes within each multi-beam manipulator device may be configured so that all of the sub-beams within a multi-beam can be deflected.

All of the pairs of electrodes within each multi-beam manipulator device may be configured so that each pair of electrodes is capable of deflecting only one line of sub-beams in the multi-beam. Alternatively, one or more of the pairs of electrodes within each multi-beam manipulator device may be configured so that they are capable of deflecting two or more lines of sub-beams in the multi-beam.

All of the pairs of electrodes within each multi-beam manipulator device may be configured so that they are arranged in the same plane as each other, the plane being substantially orthogonal to the charged particle optical axis of the multi-beam (i.e. the path of the multi-beam).

All of the pairs of electrodes within each multi-beam manipulator device may be configured so that the applied electric field between each pair of electrodes is substantially orthogonal to the charged particle optical axis. The applied electric field between each pair of electrodes may be substantially constant when the multi-beam manipulator device is in operation.

Each pair of electrodes within each multi-beam manipulator device may be configured so that the applied electric field differs in direction and/or magnitude from the electric fields applied by the other pairs of electrodes. The applied deflection to any one of the paths of a line of sub-beams in a multi-beam may therefore differ in direction and/or magnitude from the applied deflection by any other one of the paths of a line of sub-beams. Each applied electric field may be equal in magnitude, and opposite in direction, to an applied electric field by another applied electric field. The applied electric fields in a multi-beam manipulator device may be arranged to deflect the paths of lines of sub-beams such that the path of each line of sub-beams crosses the paths of all of the other lines of sub-beams down beam from the multi-beam manipulator device. In an arrangement the applied electric field may be dependent on the distance of a respective pair of parallel plates is from the middle point of the array and additionally or alternatively, the direction of the electric field applied between parallel plate pairs may depend on the direction of the pair to the middle point of the array. The middle point may correspond to the location of the electron-optical axis in a direction across the array of parallel plates (as opposed along the lines of the beams with respect a specific array).

As described above, embodiments also include a multi-beam manipulator arrangement. The multi-beam manipulator arrangement comprises a plurality of multi-beam manipulator devices arranged at different positions along the charged particle optical axis and/or the path of a multi-beam. The axis of each multi-beam manipulator device may be aligned in different directions. For example, the multi-beam manipulator arrangement may comprise multi-beam manipulator devices with axes that are aligned in orthogonally to each other and/or multi-beam manipulator devices with axes that are aligned at 30, 60, 90, 120 or 150 degrees to each other.

A multi-beam charged particle apparatus, such as an illuminator, may comprise a source of charged particles arranged to emit a beam of charged particles, and a multi-beam generator arranged to generate a multi-beam of charged particles in dependence on the beam. The charged particle apparatus may comprise a multi-beam manipulator device, and/or multi-beam manipulator arrangement, according to the above described embodiments that are capable of manipulating lines of sub-beams in the multi-beam of charged particles.

The charged particle optical axis of the multi-beam charged particle apparatus may be defined as parallel to the average direction of sub-beams in the multi-beam output from the multi-beam generator.

The multi-beam charged particle apparatus may further comprise, for each one of the sub-beams, one or more manipulators for manipulating the sub-beam, and/or the path of the sub-beam. All of the sub-beams, or sub-beam paths, can thereby be individually manipulated by a manipulator array. The manipulator array may be configured to substantially collimate the paths of the sub-beams in the multi-beam, or apply any other type of manipulation. Each of the individual manipulators in the manipulator array may comprise, for example, a quadrupole, octupole or dodecapole electrode arrangement. As described above, the use of one or more manipulator devices according to embodiments can result in the manipulators only being required to apply fine manipulations to the sub-beam paths and this can provide a number of advantages, such as simplification of the design and implementation of the manipulator array as well as an increase in number and density of individual manipulators in the manipulator array. Fine manipulation may be achieved at low operating voltages, reducing the wiring and routing requirements.

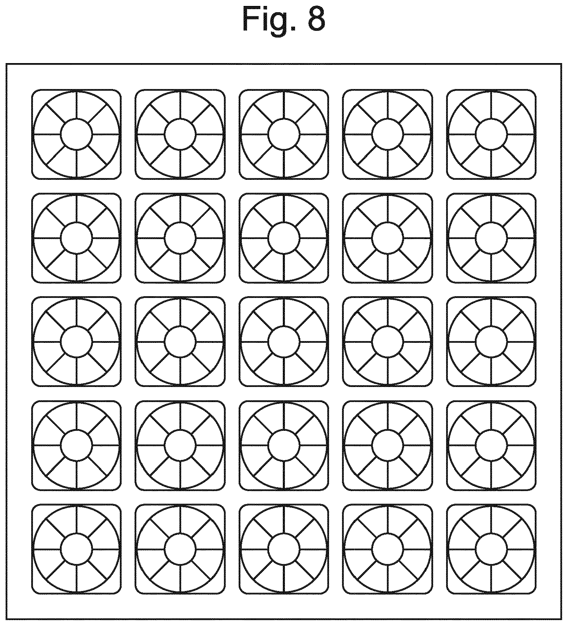

As shown in FIG. 8, the individual manipulators for manipulating the sub-beams may be arranged in a manipulator array. FIG. 8 shows a manipulator array for manipulating 25 sub-beams that are arranged in a square grid. The manipulator array may comprise a different number and arrangement of manipulators, as required for operation with the number and arrangement of sub-beams in a multi-beam.

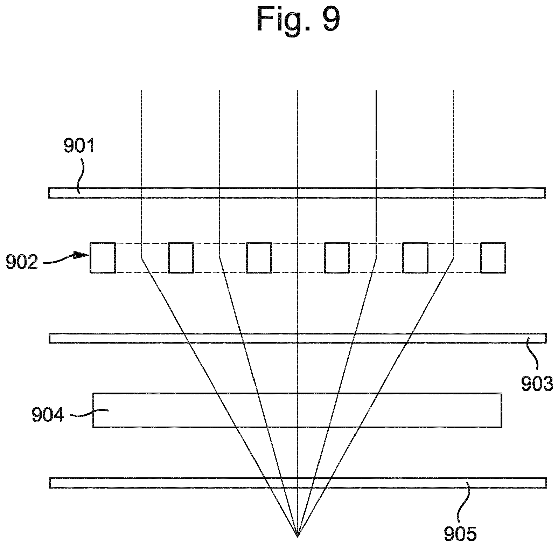

FIG. 9 is a schematic diagram showing a cross-section, in the z-y plane, through part of a charged particle apparatus. As shown in FIG. 9, 902 may be a manipulator device according to embodiments that is aligned along the x-axis. 904 may be a manipulator device according to embodiments that is aligned along the y-axis. A manipulator array may be provided in the multi-beam path at one or more of the positions 901, 903 or 905. Accordingly, more than one manipulator array may be provided. The amount of aberrations caused by manipulators in a manipulator array may be minimal when the sub-beam paths through the manipulators are all substantially normal to the plane of the manipulator array. This may be an advantage of positioning one or more of the manipulator arrays in such positions along the charged particle axis, for example all of the manipulator arrays may be located up-beam of the manipulator devices (e.g. at position 901 in FIG. 9).

The part of a charged particle apparatus shown in FIG. 9 is arranged to converge a plurality of sub-beams to a focal point. Due to the convergence of the sub-beams, the pitch, i.e. separation, between adjacent components in the manipulator array may be lower in the y-direction for a manipulator array positioned at 903 than for a manipulator array positioned at 901. Similarly, the pitch between adjacent components in the manipulator array may be lower in the x-direction for a manipulator array positioned at 905 than for a manipulator array positioned at 901 and/or 903.

The driving signals of the manipulator devices and/or manipulator arrays may be varied so as to control the position of the focal point of the sub-beams along the charged particle optical axis and/or to control the position of the focal point in the x-y plane. The manipulator devices may also be configured to apply corrections to any errors in the x-position and/or y-position of the sub-beams.

Embodiments also include the sub-beams entering the part of the charged particle apparatus being divergent so that the multi-beam is a broadening beam. The manipulator devices may be arranged to collimate the divergent sub-beams. In this configuration, the pitch between components of the manipulator array may alternatively increase with the down beam location of the manipulator array.

It should be noted that FIG. 9 is not drawn to scale. In a typical implementation of the charged particle apparatus, the separation in the z-direction between each of the manipulator arrays and manipulator devices may be a few millimeters. The distance in the z-direction to the focal point of the sub-beams may be a few hundred millimeters from the location of the manipulator devices.

Embodiments also include providing one or more stigmators in the path of the multi-beam. A stigmator array having the structure of the manipulator array may be positioned at one or more of the locations 901, 903 and 905 in **FIG. 9,** and/or up-beam and/or down beam of this part of the charged particle apparatus. Each stigmator element is a multipole electrode device. Each stigmator may comprise a shield for protection. The shield may be a immediately up beam of the array of stigmator elements to protect the stigmator elements from stay electrons. The shield may take the form of a substrate with apertures corresponding in position to those of the stigmator array.

Embodiments include there being any number, and arrangement, of sub-beams within the multi-beam. For example, the arrangement of sub-beams in the multi-beam may be n by m, where: n is 3, 11, 1000 or higher; and m is 3, 11, 1000 or higher.

The height of each electrode of the manipulator device, i.e. the length along the charged particle optical axis, may be a few hundred micrometers, such as about $300\mu$m.

The space between two electrodes in a pair of electrodes may be between about $50\mu$m and a few hundred micrometers.

Each electrode may be made from, for example, metal coated silicon or highly doped silicon.

Embodiments include a number of modifications and variations to the techniques described above.

The multi-beam charged particle apparatus could be a component of an inspection (or metro-inspection) tool or part of an e-beam lithography tool. The multi-beam charged particle apparatus according to embodiments may be used in a number of different applications that include electron microscopy in general, not just SEM, and lithography.

Embodiments include a multi-beam inspection and/or metrology tool that comprises the above-described the manipulator device according to embodiments. The manipulator device may be part of a scanning device arranged to project a multi-beam of charged particles onto a sample. The multi-beam inspection tool may comprise a detector that is arranged to detect charged particles, such as secondary electrons, that are received from the illuminated sample.

Embodiments also include a multi-beam lithography tool that comprises the above-described manipulator device according to embodiments.

In particular, the multi-beam charged particle apparatus may comprise both a manipulator device according to embodiments and any of the components of the apparatuses described above with reference to **FIGS. 1 to 3.**

The multi-beam charged particle apparatus may comprise a single source of charged particles, as shown in **FIGS. 1 to 3.** Alternatively, the multi-beam charged particle apparatus may comprise a plurality of sources of charged particles. There may be a separate column for each source and a manipulator devices according to embodiments provided in each column. Alternatively, the multi-beam charged particle apparatus may comprise a plurality of sources of charged particles and only a single column. The one or more manipulator devices according to embodiments may be provided in the single column.

Throughout embodiments a charged particle optical axis is described. This axis describes the path of charged particles through and output from the illumination apparatus. The sub-beams of an output multi-beam may all be substantially parallel to the charged particle optical axis. The charged particle optical axis may be the same as, or different from, a mechanical axis of the illumination apparatus.

Embodiments include the following statements.

According to a first aspect of the invention, there is provided a multi-beam manipulator device configured to operate on the paths of a plurality of sub-beams in a multi-beam of charged particles to thereby deflect the plurality of sub-beam paths, wherein the sub-beams arranged in an array in which the sub-beams are arranged in a plurality of lines, the multi-beam manipulator device comprising: a set of electrodes comprising a plurality of pairs of parallel planar electrode surfaces; wherein: a first pair of parallel planar electrode surfaces in the set comprises a first planar electrode surface that is arranged along a side of one of the lines of sub-beams and a second planar electrode surface that is arranged parallel to the first planar electrode surface and along an opposite side of said one of the lines of sub-beam paths; a second pair of parallel planar electrode surfaces in the set comprises a first planar electrode surface that is arranged along a side of a different one of the lines of sub-beam paths and a second planar electrode surface that is arranged parallel to the first planar electrode surface and along an opposite side of said different one of the lines of sub-beam paths; the first pair of parallel planar electrode surfaces is configured to electro-statically interact with an entire line of sub-beams in the multi-beam so that it is capable of applying a first deflection amount to the paths of sub-beams in a first direction; the second pair of parallel planar electrode surfaces is configured to electro-statically interact with an entire line of sub-beams in the multi-beam so that it is capable of applying a second deflection amount to the paths of sub-beams in a second direction; and the first direction is opposite to the second direction.

Preferably, the magnitude of the first deflection amount is different from the magnitude of the second deflection amount.

Preferably, each pair of parallel planar electrode surfaces in the set is configured to electro-statically interact with an entire line of sub-beams in the multi-beam to thereby apply a deflection to the paths of sub-beams.

Preferably, the plurality of pairs of parallel planar electrode surfaces are configured so that they are capable of deflecting all of the lines of sub-beams in the array, the lines of sub-beams being substantially parallel with each other across the array.

Preferably, the plurality of pairs of parallel planar electrode surfaces are configured so that they are capable of deflecting at least two, but not all, of the lines of sub-beams in the array, the lines of sub-beams being substantially parallel with each other across the array.

Preferably, each pair of parallel planar electrode surfaces in the set is configured so that it is capable of deflecting only one line of sub-beams in the multi-beam.

Preferably, wherein all of the pairs of parallel planar electrode surfaces are arranged in the same plane as each other, the plane being substantially orthogonal to the charged particle optical axis.

Preferably, each pair of parallel planar electrode surfaces is configured to apply an electric field between its first and second planar surfaces for electrostatically deflecting all of the paths of sub-beams in a line of sub-beams; and the applied electric field is substantially orthogonal to the charged particle optical axis.

Preferably, when in use, each pair of parallel planar electrode surfaces applies a substantially constant electric field between its first and second planar surfaces for deflecting the paths of all of the sub-beams in a line of sub-beams.

Preferably, each pair of parallel planar electrode surfaces is configured to apply an electric field that differs in direction and/or magnitude from the electric fields applied by the other pairs of parallel planar electrode surfaces such that the applied deflection to each line of sub-beams in a multi-beam is different in direction and/or magnitude.

Preferably, for each of one or more pairs of parallel planar electrode surfaces, the applied electric field by a pair of parallel planar electrode surfaces is equal in magnitude, and opposite in direction, to the applied electric field by another pair of parallel planar electrode surfaces.

Preferably, when viewed along the charged particle optical axis, the positions of the sub-beams within the multi-beam substantially correspond to the vertices of a substantially square grid, a substantially rhombic grid and/or a substantially skewed or shifted square grid.

Preferably, when viewed along the charged particle optical axis, the positions of the sub-beams within the multi-beam substantially correspond to the vertices of a substantially hexagonal grid and/or a substantially skewed or shifted hexagonal grid.

According to a second aspect of the invention, there is provided a multi-beam manipulator arrangement comprising: a first multi-beam manipulator device according to the first aspect; and one or more further multi-beam manipulator devices, wherein each of the one or more further multi-beam manipulator devices is a multi-beam manipulator device according to the first aspect; wherein, each multi-beam manipulator device is arranged at a different position along the charged particle optical axis of the multi-beam manipulator arrangement.

Preferably, the pairs of planar electrode surfaces are aligned in the same direction within each multi-beam manipulator device; and in a different direction in each multi-beam manipulator device.

Preferably, the multi-beam manipulator arrangement comprises a second multi-beam manipulator device; and the pairs of planar electrode surfaces in the second multi-beam manipulator device are aligned substantially orthogonally and down-path with respect to the first multi-beam manipulator device.

Preferably, the multi-beam manipulator arrangement comprises a second multi-beam manipulator device; the multi-beam manipulator arrangement comprises a third multi-beam manipulator device; and the pairs of planar electrode surfaces in the first, second and third multi-beam manipulator devices are each aligned in a different direction.

Preferably, the array comprises three different sets of lines, wherein each set of lines is aligned in a different direction.

Preferably, for at least one of the multi-beam manipulator devices, the one or more pairs of parallel electrode surfaces are configured to deflect the path of each line of sub-beams such that the path of each line of sub-beams crosses the paths of all of the other lines of sub-beams down-beam from the at least one of the multi-beam manipulator devices.

According to a third aspect of the invention, there is provided a charged particle system comprising: a source of charged particles arranged to emit a beam; a multi-beam generator arranged to generate a multi-beam in dependence on the beam, wherein the multi-beam comprises a plurality of sub-beams; and either a multi-beam manipulator device according to the first aspect, or a multi-beam manipulator arrangement according to the second aspect, configured to manipulate the paths of sub-beams in the multi-beam generated by the multi-beam generator.

Preferably, the charged particle optical axis is defined as parallel to the average direction of sub-beams in the multi-beam output from the multi-beam generator.

Preferably, the system further comprises, for each of the sub-beams, one or more manipulators for manipulating the path of the sub-beam such that the sub-beam paths can be individually manipulated.

Preferably, the manipulators for manipulating the sub-beams are configured to substantially collimate the sub-beam paths in the multi-beam.

Preferably, the charged particles are electrons.

According to a fourth aspect of the invention, there is provided an e-beam inspection tool comprising a charged particle system according to the third aspect.

According to a fifth aspect of the invention, there is provided an e-beam lithography tool comprising a charged particle system according to the third aspect.

According to a sixth aspect of the invention, there is provided a multi-beam manipulator device configured to operate on a plurality of sub-beam paths in a multi-beam of charged particles so as to deflect the plurality of sub-beam paths, wherein the sub-beams arranged in an array in which the sub-beams are arranged in a series of lines, the multi-beam manipulator device comprising: a plurality of pairs of parallel planar electrode surfaces; wherein: a first pair of parallel planar electrode surfaces comprises two opposing planar, parallel electrode surfaces that are arranged either side along at least one of the lines of sub-beams; a second pair of parallel planar electrode surfaces comprises two opposing planar, parallel electrode surfaces that are arranged either side along at least another of the lines of sub-beams; the first pair and second pair of parallel planar electrode surfaces extend across the multi-beam to cross the array and are configured, in operation, to interact electrostatically with the respective sub-beam paths in the lines between the pairs of surfaces.

According to a seventh aspect of the invention, there is provided a multi-beam manipulator configured to manipulate an array of sub-beam paths of a multi-beam of charged particles, the sub-beams arranged in lines in the array, the lines being in at least two different line directions, the multi-beam manipulator device comprising: a number of deflector devices corresponding to the number of line directions in the array and arranged at different positions on the path of the multi-beam, wherein, each deflector device comprises a plurality of pairs of parallel planar electrode surfaces, the parallel planar electrode surfaces of each deflector device aligned with a different line direction, the plurality of pairs of parallel planar electrode surfaces comprising: a first pair of parallel planar electrode surfaces comprising two opposing planar, parallel electrode surfaces that are arranged either side along at least one of the lines of sub-beams; a second pair of parallel planar electrode surfaces comprising two opposing planar, parallel electrode surfaces that are arranged either side along at least another of the lines of sub-beams, the at least another of the lines of sub-beams being parallel with the at least one of the lines of sub-beams; and the first pair and second pair of parallel planar electrode surfaces extending across the multi-beam to cross the array and configured, in operation, to interact electrostatically with the respective sub-beam paths in the lines between the pairs of surfaces.

According to an eighth aspect of the invention, there is provided a multi-beam manipulator configured to manipulate an array of sub-beam paths of a multi-beam of charged particles, the sub-beams arranged in lines in the array, the lines being in at least two different line directions, the multi-beam manipulator device comprising: a number of deflector devices corresponding to the number of line directions in the array and positioned along the multi-beam path, wherein each deflector device comprises a plurality planar, parallel opposing electrode surfaces, the planar, parallel electrode surfaces of each deflector device aligned with a different line direction, the plurality of pairs of parallel planar electrode surfaces comprising: at least two pairs of opposing parallel planar electrode surfaces in which each pair of opposing planar, parallel surfaces are configured to cross across the multi-beam array either side of different at least one line of sub-beam paths, so that in operation each pair of opposing parallel planar electrode surfaces interact electrostatically with all of the sub-beam paths in the respective at least one line between said surfaces.

Preferably, the multi-beam manipulator is configured to deflect the sub-beams to a focus.

According to a ninth aspect of the invention, there is provided a method of deflecting the paths of a plurality of sub-beams in a multi-beam of charged particles, wherein the sub-beams arranged in an array in which the sub-beams are arranged in a plurality of lines, the method comprising: electro-statically interacting with a first entire line of sub-beams in the multi-beam so that a first deflection amount is applied to the paths of the sub-beams in a first direction; and electro-statically interacting with a second entire line of sub-beams in the multi-beam so that a second deflection amount is applied to the paths of sub-beams in a second direction, wherein the first direction is opposite to the second direction.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims.

The descriptions above are intended to be illustrative, not limiting. Thus, it will be apparent to one skilled in the art that modifications may be made as described without departing from the scope of the claims set out below.

There is disclosed in arrangement according to the following clauses:

Clause 1: A multi-beam manipulator device configured to operate on the paths of a plurality of sub-beams in a multi-beam of charged particles to thereby deflect the plurality of sub-beam paths, wherein the sub-beams arranged in an array in which the sub-beams are arranged in a plurality of lines, the multi-beam manipulator device comprising: a set of electrodes comprising a plurality of pairs of parallel planar electrode surfaces; wherein:

a first pair of parallel planar electrode surfaces in the set comprises a first planar electrode surface that is arranged along a side of one of the lines of sub-beams and a second planar electrode surface that is arranged parallel to the first planar electrode surface and along an opposite side of said one of the lines of sub-beam paths; a second pair of parallel planar electrode surfaces in the set comprises a first planar electrode surface that is arranged along a side of a different one of the lines of sub-beam paths and a second planar electrode surface that is arranged parallel to the first planar electrode surface and along an opposite side of said different one of the lines of sub-beam paths;

the first pair of parallel planar electrode surfaces is configured to electro-statically interact with an entire line of sub-beams in the multi-beam so that it is capable of applying a first deflection amount to the paths of sub-beams in a first direction;

the second pair of parallel planar electrode surfaces is configured to electro-statically interact with an entire line of sub-beams in the multi-beam so that it is capable of applying a second deflection amount to the paths of sub-beams in a second direction; and

the first direction is opposite to the second direction.

Clause 2: The multi-beam manipulator device according to clause 1, wherein the magnitude of the first deflection amount is different from the magnitude of the second deflection amount.

Clause 3: The multi-beam manipulator device according to clause 1 or 2, wherein each pair of parallel planar electrode surfaces in the set is configured to electro-statically interact with an entire line of sub-beams in the multi-beam to thereby apply a deflection to the paths of sub-beams.

Clause 4: The multi-beam manipulator device according to any preceding clause, wherein the plurality of pairs of parallel planar electrode surfaces are configured so that they are capable of deflecting all of the lines of sub-beams in the array, the lines of sub-beams being substantially parallel with each other across the array.

Clause 5: The multi-beam manipulator device according to any of clauses 1 to 3, wherein the plurality of pairs of parallel planar electrode surfaces are configured so that they are capable of deflecting at least two, but not all, of the lines of sub-beams in the array, the lines of sub-beams being substantially parallel with each other across the array.

Clause 6: The multi-beam manipulator device according to any preceding clause, wherein each pair of parallel planar electrode surfaces in the set is configured so that it is capable of deflecting only one line of sub-beams in the multi-beam.

Clause 7: The multi-beam manipulator device according to any preceding clause, wherein all of the pairs of parallel planar electrode surfaces are arranged in the same plane as each other, the plane being substantially orthogonal to the charged particle optical axis.

Clause 8: The multi-beam manipulator device according to any preceding clause, wherein each pair of parallel planar electrode surfaces is configured to apply an electric field between its first and second planar surfaces for electro-statically deflecting all of the paths of sub-beams in a line of sub-beams; and the applied electric field is substantially orthogonal to the charged particle optical axis.

Clause 9: The multi-beam manipulator device according to any preceding clause, wherein, when in use, each pair of parallel planar electrode surfaces applies a substantially constant electric field between its first and second planar surfaces for deflecting the paths of all of the sub-beams in a line of sub-beams.

Clause 10: The multi-beam manipulator device according to any preceding clause, wherein each pair of parallel planar electrode surfaces is configured to apply an electric field that differs in direction and/or magnitude from the electric fields applied by the other pairs of parallel planar electrode surfaces such that the applied deflection to each line of sub-beams in a multi-beam is different in direction and/or magnitude.

Clause 11: The multi-beam manipulator device according to any preceding clause, wherein, for each of one or more pairs of parallel planar electrode surfaces, the applied electric field by a pair of parallel planar electrode surfaces is equal in magnitude, and opposite in direction, to the applied electric field by another pair of parallel planar electrode surfaces.

Clause 12: The multi-beam manipulator device according to any preceding clause, wherein, when viewed along the charged particle optical axis, the positions of the sub-beams within the multi-beam substantially correspond to the vertices of a substantially square grid, a substantially rhombic grid and/or a substantially skewed or shifted square grid.

Clause 13: The multi-beam manipulator device according to any of clauses 1 to 11, wherein, when viewed along the charged particle optical axis, the positions of the sub-beams within the multi-beam substantially correspond to the vertices of a substantially hexagonal grid and/or a substantially skewed or shifted hexagonal grid.

Clause 14: A multi-beam manipulator arrangement comprising: a first multi-beam manipulator device according to any preceding clause; and one or more further multi-beam manipulator devices, wherein each of the one or more further multi-beam manipulator devices is a multi-beam manipulator device according to any preceding clause; wherein, each multi-beam manipulator device is arranged at a different position along the charged particle optical axis of the multi-beam manipulator arrangement.

Clause 15: The multi-beam manipulator arrangement according to clause 14, wherein the pairs of planar electrode surfaces are aligned: in the same direction within each multi-beam manipulator device; and in a different direction in each multi-beam manipulator device.

Clause 16: The multi-beam manipulator arrangement according to clause 14 or 15, wherein the multi-beam manipulator arrangement comprises a second multi-beam manipulator device; and the pairs of planar electrode surfaces in the second multi-beam manipulator device are aligned substantially orthogonally and down-path with respect to the first multi-beam manipulator device.

Clause 17: The multi-beam manipulator arrangement according to any of clauses 14 or 15, wherein: the multi-beam manipulator arrangement comprises a second multi-beam manipulator device; the multi-beam manipulator arrangement comprises a third multi-beam manipulator device; and the pairs of planar electrode surfaces in the first, second and third multi-beam manipulator devices are each aligned in a different direction.

Clause 18: The multi-beam manipulator arrangement according to clause 17, wherein the array comprises three different sets of lines, wherein each set of lines is aligned in a different direction.

Clause 19: The multi-beam manipulator arrangement according to any of clauses 14 to 18, wherein, for at least one of the multi-beam manipulator devices, the one or more pairs of parallel electrode surfaces are configured to deflect the path of each line of sub-beams such that the path of each line of sub-beams crosses the paths of all of the other lines of sub-beams down-beam from the at least one of the multi-beam manipulator devices.

Clause 20: A charged particle system comprising: a source of charged particles arranged to emit a beam; a multi-beam generator arranged to generate a multi-beam in dependence on the beam, wherein the multi-beam comprises a plurality of sub-beams; and either a multi-beam manipulator device according to any of clauses 1 to 13, or a multi-beam manipulator arrangement according to any of clauses 14 to 19, configured to manipulate the paths of sub-beams in the multi-beam generated by the multi-beam generator.

Clause 21; The charged particle system according to clause 20, wherein the charged particle optical axis is defined as parallel to the average direction of sub-beams in the multi-beam output from the multi-beam generator.

Clause 22: The charged particle system according to clause 20 or 21, wherein the system further comprises, for each of the sub-beams, one or more manipulators for manipulating the path of the sub-beam such that the sub-beam paths can be individually manipulated.

Clause 23: The charged particle system according to any of clauses 20 to 22, wherein the manipulators for manipulating the sub-beams are configured to substantially collimate the sub-beam paths in the multi-beam.

Clause 24; The charged particle system according to any of clauses 20 to 23, wherein the charged particles are electrons.

Clause 25: An e-beam inspection tool comprising a charged particle system according to any of clauses 20 to 24.

Clause 26: An e-beam lithography tool comprising a charged particle system according to any of clauses 20 to 24.

Clause 27: A multi-beam manipulator device configured to operate on a plurality of sub-beam paths in a multi-beam of charged particles so as to deflect the plurality of sub-beam paths, wherein the sub-beams arranged in an array in which the sub-beams are arranged in a series of lines, the multi-beam manipulator device comprising: a plurality of pairs of parallel planar electrode surfaces; wherein:

a first pair of parallel planar electrode surfaces comprises two opposing planar, parallel electrode surfaces that are arranged either side along at least one of the lines of sub-beams; a second pair of parallel planar electrode surfaces comprises two opposing planar, parallel electrode surfaces that are arranged either side along at least another of the lines of sub-beams; the first pair and second pair of parallel planar electrode surfaces extend across the multi-beam to cross the array and are configured, in operation, to interact electrostatically with the respective sub-beam paths in the lines between the pairs of surfaces.

Clause 28: A multi-beam manipulator configured to manipulate an array of sub-beam paths of a multi-beam of charged particles, the sub-beams arranged in lines in the array, the lines being in at least two different line directions, the multi-beam manipulator device comprising: a number of deflector devices corresponding to the number of line directions in the array and arranged at different positions on the path of the multi-beam, wherein, each deflector device comprises a plurality of pairs of parallel planar electrode surfaces, the parallel planar electrode surfaces of each deflector device aligned with a different line direction, the plurality of pairs of parallel planar electrode surfaces comprising:

a first pair of parallel planar electrode surfaces comprising two opposing planar, parallel electrode surfaces that are arranged either side along at least one of the lines of sub-beams; a second pair of parallel planar electrode surfaces comprising two opposing planar, parallel electrode surfaces that are arranged either side along at least another of the lines of sub-beams, the at least another of the lines of sub-beams being parallel with the at least one of the lines of sub-beams; and the first pair and second pair of parallel planar electrode surfaces extending across the multi-beam to cross the array and configured, in operation, to interact electrostatically with the respective sub-beam paths in the lines between the pairs of surfaces.

Clause 29: A multi-beam manipulator configured to manipulate an array of sub-beam paths of a multi-beam of charged particles, the sub-beams arranged in lines in the array, the lines being in at least two different line directions, the multi-beam manipulator device comprising: a number of deflector devices corresponding to the number of line directions in the array and positioned along the multi-beam path, wherein each deflector device comprises a plurality planar, parallel opposing electrode surfaces, the planar, parallel electrode surfaces of each deflector device aligned with a different line direction, the plurality of pairs of parallel planar electrode surfaces comprising:

at least two pairs of opposing parallel planar electrode surfaces in which each pair of opposing planar, parallel surfaces are configured to cross across the multi-beam array either side of different at least one line of sub-beam paths, so that in operation each pair of opposing parallel planar electrode surfaces interact electrostatically with all of the sub-beam paths in the respective at least one line between said surfaces.

Clause 30: The multi-beam manipulator according to clause 29, wherein the multi-beam manipulator is configured to deflect the sub-beams to a focus.

Clause 31: A method of deflecting the paths of a plurality of sub-beams in a multi-beam of charged particles, wherein the sub-beams arranged in an array in which the sub-beams are arranged in a plurality of lines, the method comprising:

electro-statically interacting with a first entire line of sub-beams in the multi-beam so that a first deflection amount is applied to the paths of the sub-beams in a first direction; and electro-statically interacting with a second entire line of sub-beams in the multi-beam so that a second deflection amount is applied to the paths of sub-beams in a second direction, wherein the first direction is opposite to the second direction.

## Claims

1. A multi-beam manipulator device configured to operate on the paths of a plurality of sub-beams in a multi-beam of charged particles to thereby deflect the plurality of sub-beam paths, wherein the sub-beams arranged in an array in which the sub-beams are arranged in a plurality of lines, the multi-beam manipulator device comprising:

a set of electrodes comprising a plurality of pairs of parallel planar electrode surfaces; wherein:

a first pair of parallel planar electrode surfaces in the set comprises a first planar electrode surface that is arranged along a side of one of the lines of sub-beams and a second planar electrode surface that is arranged parallel to the first planar electrode surface and along an opposite side of said one of the lines of sub-beam paths; a second pair of parallel planar electrode surfaces in the set comprises a first planar electrode surface that is arranged along a side of a different one of the lines of sub-beam paths and a second planar electrode surface that is arranged parallel to the first planar electrode surface and along an opposite side of said different one of the lines of sub-beam paths; the first pair of parallel planar electrode surfaces is configured to electro-statically interact with an entire line of sub-beams in the multi-beam so that it is capable of applying a first deflection amount to the paths of sub-beams in a first direction; the second pair of parallel planar electrode surfaces is configured to electro-statically interact with an entire line of sub-beams in the multi-beam so that it is capable of applying a second deflection amount to the paths of sub-beams in a second direction; and the first direction is opposite to the second direction.

2. The multi-beam manipulator device according to claim 1, wherein the magnitude of the first deflection amount is different from the magnitude of the second deflection amount.

3. The multi-beam manipulator device according to claim 1 or 2, wherein each pair of parallel planar electrode surfaces in the set is configured to electro-statically interact with an entire line of sub-beams in the multi-beam to thereby apply a deflection to the paths of sub-beams.

4. The multi-beam manipulator device according to any preceding claim, wherein the plurality of pairs of parallel planar electrode surfaces are configured so that they are capable of deflecting all of the lines of sub-beams in the array, the lines of sub-beams being substantially parallel with each other across the array.

5. The multi-beam manipulator device according to any of claims 1 to 3, wherein the plurality of pairs of parallel planar electrode surfaces are configured so that they are capable of deflecting at least two, but not all, of the lines of sub-beams in the array, the lines of sub-beams being substantially parallel with each other across the array.

6. The multi-beam manipulator device according to any preceding claim, wherein each pair of parallel planar electrode surfaces in the set is configured so that it is capable of deflecting only one line of sub-beams in the multi-beam.

7. The multi-beam manipulator device according to any preceding claim, wherein all of the pairs of parallel planar electrode surfaces are arranged in the same plane as each other, the plane being substantially orthogonal to the charged particle optical axis.

8. The multi-beam manipulator device according to any preceding claim, wherein each pair of parallel planar electrode surfaces is configured to apply an electric field between its first and second planar surfaces for electro-statically deflecting all of the paths of sub-beams in a line of sub-beams; and the applied electric field is substantially orthogonal to the charged particle optical axis.

9. The multi-beam manipulator device according to any preceding claim, wherein, when in use, each pair of parallel planar electrode surfaces applies a substantially constant electric field between its first and second planar surfaces for deflecting the paths of all of the sub-beams in a line of sub-beams.

10. The multi-beam manipulator device according to any preceding claim, wherein each pair of parallel planar electrode surfaces is configured to apply an electric field that differs in direction and/or magnitude from the electric fields applied by the other pairs of parallel planar electrode surfaces such that the applied deflection to each line of sub-beams in a multi-beam is different in direction and/or magnitude.

11. The multi-beam manipulator device according to any preceding claim, wherein, for each of one or more pairs of parallel planar electrode surfaces, the applied electric field by a pair of parallel planar electrode surfaces is equal in magnitude, and opposite in direction, to the applied electric field by another pair of parallel planar electrode surfaces.

12. The multi-beam manipulator device according to any preceding claim, wherein, when viewed along the charged particle optical axis, the positions of the sub-beams within the multi-beam substantially correspond to the vertices of a substantially square grid, a substantially rhombic grid and/or a substantially skewed or shifted square grid.

13. The multi-beam manipulator device according to any of claims 1 to 11, wherein, when viewed along the charged particle optical axis, the positions of the sub-beams within the multi-beam substantially correspond to the vertices of a substantially hexagonal grid and/or a substantially skewed or shifted hexagonal grid.

14. A multi-beam manipulator arrangement comprising:

a first multi-beam manipulator device according to any preceding claim; and one or more further multi-beam manipulator devices, wherein each of the one or more further multi-beam manipulator devices is a multi-beam manipulator device according to any preceding claim; wherein, each multi-beam manipulator device is arranged at a different position along the charged particle optical axis of the multi-beam manipulator arrangement.

15. A method of deflecting the paths of a plurality of sub-beams in a multi-beam of charged particles, wherein the sub-beams arranged in an array in which the sub-beams are arranged in a plurality of lines, the method comprising:

electro-statically interacting with a first entire line of sub-beams in the multi-beam so that a first deflection amount is applied to the paths of the sub-beams in a first direction; and electro-statically interacting with a second entire line of sub-beams in the multi-beam so that a second deflection amount is applied to the paths of sub-beams in a second direction, wherein the first direction is opposite to the second direction.

# Fig. 1

100

# Fig. 2

# Fig. 3

# Fig. 4

# Fig. 5

# Fig. 6

601

602

603

z

x

y

## Fig. 7A

# Fig. 7B

Fig. 8

# Fig. 9

901

902

903

904

905

Europäisches
Patentamt

European
Patent Office

Office européen
des brevets

# EUROPEAN SEARCH REPORT

Application Number

EP 20 15 6253

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 2 701 178 A2 (MAPPER LITHOGRAPHY IP BV [NL]) 26 February 2014 (2014-02-26)<br>* paragraph [0053] - paragraph [0058] *<br>* paragraph [0072] - paragraph [0077]; figures 4,5 * | 1,3-7, 11-13,15 | INV.<br>H01J37/153 |
| X | US 2005/087701 A1 (LAMMER-PACHLINGER WOLFGANG [AT] ET AL) 28 April 2005 (2005-04-28)<br>* paragraphs [0007] - [0012], [0017], [0018], [0020], [0054] - [0071]; figures 6-13 *<br>* paragraph [0061] - paragraph [0063] * | 1-15 | |

TECHNICAL FIELDS
SEARCHED (IPC)

H01J

The present search report has been drawn up for all claims

| Place of search | Date of completion of the search | Examiner |
|---|---|---|
| Munich | 20 July 2020 | Krauss, Jan |

## ANNEX TO THE EUROPEAN SEARCH REPORT
## ON EUROPEAN PATENT APPLICATION NO.

EP 20 15 6253

This annex lists the patent family members relating to the patent documents cited in the above-mentioned European search report.
The members are as contained in the European Patent Office EDP file on
The European Patent Office is in no way liable for these particulars which are merely given for the purpose of information.

20-07-2020

| Patent document cited in search report | | Publication date | Patent family member(s) | | Publication date |
|---|---|---|---|---|---|
| EP 2701178 | A2 | 26-02-2014 | AU | 2003276779 A1 | 25-05-2004 |
| | | | CN | 1708826 A | 14-12-2005 |
| | | | CN | 101414124 A | 22-04-2009 |
| | | | CN | 101414125 A | 22-04-2009 |
| | | | CN | 101414126 A | 22-04-2009 |
| | | | CN | 101414127 A | 22-04-2009 |
| | | | CN | 101414128 A | 22-04-2009 |
| | | | CN | 101414129 A | 22-04-2009 |
| | | | CN | 101414533 A | 22-04-2009 |
| | | | CN | 101414534 A | 22-04-2009 |
| | | | CN | 101414535 A | 22-04-2009 |
| | | | CN | 101414536 A | 22-04-2009 |
| | | | EP | 1556881 A2 | 27-07-2005 |
| | | | EP | 2523207 A2 | 14-11-2012 |
| | | | EP | 2565902 A2 | 06-03-2013 |
| | | | EP | 2701178 A2 | 26-02-2014 |
| | | | EP | 3671804 A1 | 24-06-2020 |
| | | | JP | 5053514 B2 | 17-10-2012 |
| | | | JP | 5069331 B2 | 07-11-2012 |
| | | | JP | 2006505124 A | 09-02-2006 |
| | | | JP | 2010171452 A | 05-08-2010 |
| | | | KR | 20050065659 A | 29-06-2005 |
| | | | KR | 20100101681 A | 17-09-2010 |
| | | | KR | 20100101682 A | 17-09-2010 |
| | | | KR | 20100103650 A | 27-09-2010 |
| | | | KR | 20100103651 A | 27-09-2010 |
| | | | US | RE44240 E | 28-05-2013 |
| | | | US | RE44908 E | 27-05-2014 |
| | | | US | RE45049 E | 29-07-2014 |
| | | | US | 2004141169 A1 | 22-07-2004 |
| | | | US | 2005211921 A1 | 29-09-2005 |
| | | | WO | 2004040614 A2 | 13-05-2004 |
| US 2005087701 | A1 | 28-04-2005 | GB | 2408383 A | 25-05-2005 |
| | | | JP | 2005136409 A | 26-05-2005 |
| | | | US | 2005087701 A1 | 28-04-2005 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 2715768 A2